# EUROPÄISCHE PATENTANMELDUNG

(11) **EP 3 525 234 A1**
(43) Veröffentlichungstag der Anmeldung: **14.08.2019**
(21) Anmeldenummer: 19155758.6
(22) Anmeldetag: 06.02.2019
(51) Int. Cl.: H01L 21/687

(54) **TRÄGERVORRICHTUNG FÜR EIN FLACHES SUBSTRAT**

(30) Priorität: 07.02.2018 DE 102018102766
(71) Anmelder: Beier, Uwe, 01458 Ottendorf-Okrilla (DE)
(72) Erfinder: Beier, Uwe, 01458 Ottendorf-Okrilla (DE)
(74) Vertreter: Riechelmann & Carlsohn Patentanwälte PartG mbB

(57) **Zusammenfassung**

Die Erfindung betrifft eine Trägervorrichtung für ein flaches Substrat, wobei die Trägervorrichtung (1) ein erstes Trägerelement (10), ein zweites Trägerelement (20) und ein Klemmelement (30) aufweist, wobei das erste und das zweite Trägerelement (10, 20) miteinander unter Ausbildung eines verbundenen Zustandes lösbar verbindbar sind, dadurch gekennzeichnet, dass
- das erste Trägerelement (10) einen unter Ausbildung einer ersten Substratöffnung (12) umlaufenden Rahmen (11) aufweist, der eine der ersten Substratöffnung (12) zugewandte Stirnseite (15) besitzt, wobei an der Stirnseite (15) ein Steg (17) mit einer Oberseite (18) ausgebildet ist, die einen Haltebereich für das Substrat (91) bildet, so dass dieses mit einem Auflagebereich (95), der an einer Flächenseite (93) des Substrates (91) ausgebildet ist und an den Rand (94) des Substrates (91) angrenzt, auf dem Haltebereich aufliegen kann;
- das zweite Trägerelement (20) einen unter Ausbildung einer zweiten SubstratÖffnung (22) umlaufenden Rahmen (21) aufweist, der eine Innenseite (23) aufweist, die im verbundenen Zustand auf einer Innenseite (13) des ersten Trägerelementes (10) aufliegt, so dass die erste Substratöffnung (12) und die zweite Substratöffnung (22) fluchtend zueinander ausgerichtet sind, und das zweite Trägerelement (20) das Klemmelement (30) trägt; und
- das Klemmelement (30) das Substrat (91), wenn es im verbundenen Zustand mit einer Flächenseite (33) auf dem Haltebereich aufliegt, an seiner anderen Flächenseite (92) kontaktiert und gegen den Steg (17) des ersten Trägerelementes (10) presst.

## Beschreibung

### Die Erfindung betrifft eine Trägervorrichtung für ein flaches Substrat sowie eine Handhabevorrichtung für eine solche Trägervorrichtung

In der Halbleiterindustrie ist es in vielen Fällen nicht möglich, die Bearbeitung flacher Substrate, beispielsweise von Wafern, unter atmosphärischem Druck vorzunehmen. Stattdessen ist eine Bearbeitung unter einem Über- oder Unterdruck erforderlich. Prozessanlagen zur Bearbeitung flacher Substrate bei Über- oder Unterdruck werden im Folgenden als Druckprozessanlagen bezeichnet. Die Überwindung des Druckunterschiedes zwischen dem atmosphärischen Umgebungsdruck und dem Druck, der für die Bearbeitung des flachen Substrates in einer Prozesskammer der Druckprozessanlage herrscht, ist anlagentechnisch und energetisch anspruchsvoll sowie zeitaufwendig. Bei einigen Druckprozessanlagen ist es - abgesehen von seltenen Wartungen - nicht einmal zulässig, die Prozesskammer auf atmosphärischen Druck zu bringen. Es ist deshalb bei der Bearbeitung flacher Substrate in Druckprozessanlagen erforderlich, an jeder Stelle diejenige Lösung einzusetzen, welche die größtmögliche Prozesssicherheit gewährleistet, auch wenn dies mit höheren Investitionskosten verbunden ist. Auf diese Weise kann eine hohe Anlagenverfügbarkeit erreicht werden, so dass die mit der hohen Prozesssicherheit verbundenen Kosten aufgrund einer geringen Fehlerquote, einer hohen Ausbeute und geringen Betriebskosten innerhalb kurzer bis überschaubarer Zeit ökonomisch aufgewogen werden.

Um eine hohe Prozesssicherheit zu erreichen, hat es sich für die Handhabung von flachen Substraten in Druckprozessanlagen bewährt, die flachen Substrate vor der Bearbeitung mit Substratträgern zu verbinden. Damit stehen für die Handhabung der flachen Substrate gut automatisierbare Geometrien zur Verfügung, und das vollkommen unabhängig von der Substratgeometrie. Neben der höheren Prozesssicherheit ergibt sich damit auch der Vorteil der Unabhängigkeit von der Substratgröße, d. h. in Grenzen sind die Abmessungen des Substrates unerheblich, da die zur Handhabung verwendeten Geometriemerkmale die des Substratträgers sind und nicht die des Substrates selbst. Das bedeutet, dass für die Bearbeitung von Substraten unterschiedlicher Geometrien, wie dies beispielsweise nach einem Substratwechsel der Fall ist, keine Änderungen und/oder Umrüstungen am Handhabungssystem der Druckprozessanlage vorgenommen werden müssen. Der Einsatz von Substratträgern bietet in Druckprozessen somit mehrere Vorteile: Der Substratträger ist im Vergleich zum Substrat robust; er schützt Substrate, beispielsweise vor Substratbruch oder Kratzern; er ermöglicht eine gut automatisierbare Geometrie für die Handhabung; und ermöglicht eine Handhabung unabhängig von der Geometrie und Größe des Substrates.

Es sind einteilige und mehrteilige Substratträger bekannt. In einteilige Substratträger werden die Substrate lediglich eingelegt. Das ist einfach auszuführen, jedoch sind die Substrate dann in der Regel nicht in allen Freiheitsgraden fixiert, so dass bei der Handhabung der Substratträger die Schwerkraft zu beachten ist. Bei runden Substraten und Drehungen sind unerwünschte Substratdrehbewegungen relativ zum Substratträger nicht auszuschließen. Die Handhabung von mehrteiligen Substratträgern ist aufwendiger, vor allem wenn sie automatisiert werden soll. Dafür sind die Substrate jedoch vollständig fixiert und rundum geschützt. Außerdem ist unabhängig von der Schwerkraft jede Raumlage des Substrates einstellbar. Die Be- und Entstückung kann manuell oder automatisiert erfolgen, wobei die manuellen Varianten vor allem im Forschungsbereich oder bei kleinteiliger Produktion zum Einsatz kommen. Für eine automatisierte Be- und Entstückung, wie sie in Produktionsanlagen eingesetzt wird, sind vor allem für kleinere Substrate Sonderanlagen bekannt. Diese Sonderanlagen ermöglichen eine automatisierte Be- und Entstückung, die an sich produktiv ist. Allerdings sind die Substratträger für Druckprozessanlagen nicht standardisiert, so dass immer Sonderlösungen erforderlich sind. Wird eine separate Sortieranlage eingesetzt, so geht der Partikelschutz verloren. Das hat verschiedene Ursachen: Die Substrate müssen aus der Substratbox entnommen und in die Sortieranlage überführt werden; die Be- und Entstückung erfordert eine gewisse Zeit, die Handlingzeit; und vor allem die Lagerung und der Transport in speziellen Substratträgern, die zwar für den Druckprozess optimiert sind, aber im Allgemeinen nicht geeignet sind, die Substrate vor Partikelkontamination zu schützen, weil sie vollkommen offen gestaltet sind. Eine offene Gestaltung ist für eine Bearbeitung des Substrates in einer Druckprozessanlage zwar erforderlich, ist jedoch dennoch mit einer erhöhten Partikelbelastung verbunden. Nachteilig ist auch, dass sich die Bedienung der Substratträger von derjenigen unterscheidet, die aus den standardisierten Substratträgern bekannt ist.

Bekannte Substratträger besitzen ein hohes Gewicht, sind in der Regel aus Kupfer und haben eine hohe Dicke. Diese massiven Substratträger erschweren die Handhabung der Substratträger erheblich. Soll das gehaltene Substrat temperiert, insbesondere abgekühlt werden, so verlangsamt der Substratträger die Temperierung, weil er bei der Temperierung des Substrates ebenfalls temperiert wird.

Aufgabe der Erfindung ist es, die Nachteile nach dem Stand der Technik zu beseitigen. Es soll insbesondere eine Trägervorrichtung angegeben werden, die einen verbesserten Schutz des Substrates und eine einfachere Handhabung ermöglicht.

Diese Aufgabe wird durch die Merkmale der Ansprüche 1 und 14 gelöst. Zweckmäßige Ausgestaltungen der Erfindungen ergeben sich aus den Merkmalen der Unteransprüche.

Nach Maßgabe der Erfindung ist eine Trägervorrichtung für ein flaches Substrat vorgesehen, wobei die Trägervorrichtung ein erstes Trägerelement, ein zweites Trägerelement und ein Klemmelement aufweist. Das erste und das zweite Trägerelement sind miteinander unter Ausbildung eines verbundenen Zustandes lösbar verbindbar. Dabei ist vorgesehen, dass
- das erste Trägerelement einen unter Ausbildung einer ersten Substratöffnung umlaufenden Rahmen aufweist, der eine der ersten Substratöffnung zugewandte Stirnseite besitzt, wobei an der Stirnseite ein Steg mit einer Oberseite ausgebildet ist, die einen Haltebereich für das Substrat bildet, so dass dieses mit einem Auflagebereich, der an einer Flächenseite des Substrates ausgebildet ist und an den Rand des flachen Substrates angrenzt, auf dem Haltebereich aufliegen kann;
- das zweite Trägerelement einen unter Ausbildung einer zweiten Substratöffnung umlaufenden Rahmen aufweist, der eine Innenseite aufweist, die im verbundenen Zustand auf einer Innenseite des ersten Trägerelementes aufliegt, so dass die erste Substratöffnung und die zweite Substratöffnung fluchtend zueinander ausgerichtet sind, und das zweite Trägerelement das Klemmelement trägt; und
- das Klemmelement das flache Substrat, wenn es im verbundenen Zustand mit einer Flächenseite auf dem Haltebereich aufliegt, an seiner anderen Flächenseite kontaktiert und gegen den Steg des ersten Trägerelementes presst.

Die erfindungsgemäße Trägervorrichtung kann zur Haltung des flachen Substrates während der Bearbeitung in einer Prozessanlage dienen. Es kann ferner zur Fixierung des flachen Substrates in einer vorgegebenen Position, bezogen auf die Trägervorrichtung dienen. Damit befindet sich das Substrat in einer, bezogen auf die Trägervorrichtung, unveränderlichen Lage.

Die Substrate sind flache Substrate, beispielsweise Wafer wie Silicium-Wafer. Unter dem Begriff "flaches Substrat" wird ein Körper verstanden, der in zwei Richtungen eines kartesischen Koordinatensystems eine größere Ausdehnung, typischerweise eine sehr viel größere Ausdehnung, als in der dritten Richtung des kartesischen Koordinatensystems aufweist. Mit anderen Worten, die Breite und/oder Länge des flachen Substrates ist größer, typischerweise sehr viel größer, als dessen Dicke. Bei flachen Substraten mit im Wesentlichen kreisförmigem Querschnitt ist sein Radius größer als dessen Dicke. Die Ausdehnung des Substrates in Breite oder Länge wird im Folgenden auch als Ausdehnung in Flächenrichtung bezeichnet. Im Folgenden werden die Ausdrücke "flaches Substrat" und "Substrat" synonym verwendet. Das von der erfindungsgemäßen Trägervorrichtung gehaltene Substrat wird im Folgenden auch als "gehaltenes Substrat" oder "gehaltenes flaches Substrat" bezeichnet.

Das flache Substrat weist zwei Flächenseiten auf, die im Folgenden als Unterseite und Oberseite bezeichnet werden. Der Ausdruck "Unterseite" bezieht sich dabei auf die Flächenseite des Substartes mit der dieses auf dem Haltebereich des ersten Trägerelementes aufliegt oder aufliegen soll, und zwar unabhängig von der tatsächlichen Lage des Substrates im Raum. Der Ausdruck "Oberseite bezieht sich auf die Flächenseite des Substrates, die nicht die Unterseite ist. Vorzugsweise verlaufen die Unterseite und die Oberseite parallel und fluchtend zueinander. Das Substrat weist einen umlaufenden Rand auf. Abgesehen davon kann das Substrat eine beliebige geometrische Form aufweisen. Insbesondere können die beiden Flächenseite rund, drei- vier- oder mehreckig oder unregelmäßig geformt sein. Typischerweise sind Flächenseiten rund oder rechteckig. Das Substrat kann am Rand eine runde oder gerade Fase aufweisen. Vorzugsweise haben die beiden Flächenseiten eines Substrates die gleiche geometrische Form.

Mittels der erfindungsgemäßen Trägervorrichtung wird das Substrat zwischen dem ersten Trägerelement, dem zweiten Trägerelement und dem Klemmelement gehalten. Das Substrat kann ein Körper sein, der eine beliebige Steifigkeit besitzt. Das Substrat wird an seinem Rand über seinen gesamten Umfang von oben und von unten gehalten. Das Substrat kann daher ein Körper sein, der eine geringe Steifigkeit besitzt. Die erfindungsgemäße Trägervorrichtung ermöglicht es somit, Substrate zu halten, die sehr dünn, sensibel und/oder biegsam sind. Ein von der erfindungsgemäßen Trägervorrichtung gehaltenes Substrat bleibt selbst dann formstabil, wenn es ohne Trägervorrichtung labil ist. Bei einem sehr dünnen Körper kann es sich beispielsweise um einen Körper mit einer Dicke von 140 Mikrometer oder weniger oder um einen Körper mit einer Dicke von 70 Mikrometer oder weniger handeln.

Das Substrat kann beispielsweise aus Glas, aus Keramik, aus einem Halbleitermaterial wie Silicium, aus Kunststoff, aus einem Metall, aus einer Metalllegierung oder aus einem Verbundmaterial bestehen, wobei die Aufzählung nicht abschließend ist.

Der Rahmen des ersten Trägerelementes weist eine Innenseite, eine Außenseite, eine der ersten Substratöffnung zugewandte Stirnseite, die im Folgenden als auch als innere Stirnseite bezeichnet wird, und eine der ersten Substratöffnung abgewandte Stirnseite, die im Folgenden auch als äußere Stirnseite bezeichnet wird. Die Ausdehnung des Rahmens des ersten Trägerelementes zwischen seiner Innenseite und seiner Außenseite ist seine Dicke, die Ausdehnung orthogonal zur Dicke zwischen seinen beiden Stirnseiten seine Breite. Der Rahmen des ersten Trägerelementes ist vorzugsweise ein flacher Körper. Der Rahmen des zweiten Trägerelementes weist eine Außenseite, eine Innenseite, eine der zweiten Substratöffnung zugewandte Stirnseite, die im Folgenden auch als innere Stirnseite bezeichnet wird, und eine der zweiten Substratöffnung abgewandte Stirnseite auf, die im Folgenden auch als äußere Stirnseite bezeichnet wird. Der Rahmen des zweiten Trägerelementes kann ein flacher Körper sein. Die Ausdehnung des Rahmens des zweiten Trägerelementes zwischen seiner Innenseite und seiner Außenseite ist seine Dicke, die Ausdehnung zwischen seinen beiden Stirnseiten seine Breite. Die Innenseite des Rahmens des ersten Trägerelementes ist im verbundenen Zustand der erfindungsgemäßen Trägervorrichtung der Innenseite des Rahmens des zweiten Trägerelementes zugewandt. Unter einem flachen Körper wird ein Körper verstanden, der in zwei Richtungen eines kartesischen Koordinatensystems eine größere Ausdehnung, typischerweise eine sehr viel größere Ausdehnung, als in der dritten Richtung des kartesischen Koordinatensystems aufweist. Mit anderen Worten, die Breite und Länge des flachen Körpers ist größer, typischerweise sehr viel größer, als seine Dicke. Bei einem flachen Körper mit im Wesentlichen kreisförmigen Querschnitt ist sein Radius größer als seine Dicke.

In einer Ausführungsform der erfindungsgemäßen Trägervorrichtung weist das zweite Trägerelement eine größere Dicke als das erste Trägerelement auf. Das ist vorteilhaft, wenn das zweite Trägerelement die Gesamtstabilität der erfindungsgemäßen Trägervorrichtung gewährleisten soll und/oder wenn es zusätzliche Merkmale aufweist, die die Funktion der erfindungsgemäßen Trägervorrichtung erweitern.

Die Trägervorrichtung weist im verbundenen Zustand vorzugsweise nur eine geringe Ausdehnung, d. h. Dicke, orthogonal zu den Breiten der beiden Trägerelemente auf. Die Dicke des ersten Trägerelementes kann beispielsweise bei einem Wert in einem Bereich von 0,5 und 5 mm liegen. Die Dicke des zweiten Trägerelementes kann größer als die des ersten Trägerelementes ein. Die Dicke des zweiten Trägerelementes kann beispielsweise bei einem Wert in einem Bereich von 1 und 25 mm liegen. Die Dicke des ersten Substrates ist vorzugsweise geringer als die Dicke des Rahmens des ersten Trägerelementes. Im verbundenen Zustand kann die Summe aus der Dicke des Rahmen des erste Trägerelement und der Dicke des Rahmens des zweiten Trägerelement größer als die Dickes des Substrates sein.

Der Rahmen des ersten Trägerelementes umschließt eine erste Substratöffnung. Der Rahmen des ersten Trägerelementes umschließt eine zweite Substratöffnung. Das gehaltene Substrat liegt im Bereich der ersten Substratöffnung an seiner Unterseite frei. Im Bereich der zweiten Substratöffnung liegt es an seiner Oberseite frei.

Das Material, aus dem das erste und das zweite Trägerelement bestehen, kann von dem Material abhängen, aus dem das flache Substrat besteht, und der vorgesehenen Bearbeitung des flachen Substrates in einer Prozessanlage, während der das flache Substrat von der erfindungsgemäßen Trägervorrichtung gehalten wird. Das erste Trägerelement kann beispielweise aus einem Metall wie einem Leichtmetall, einer Legierung wie beispielsweise Stahl, z. B. Edelstahl, einem Kunststoff, einer Keramik, einem Glas, z. B. einem technischen Glas, bestehen. Vorzugsweise besteht das erste Trägerelement aus einem Leichtmetall oder einer Leichtmetalllegierung, besonders bevorzugt aus Aluminium oder einer Aluminiumlegierung. Das zweite Trägerelement kann beispielweise aus einem Metall wie einem Leichtmetall, einer Legierung wie beispielsweise Stahl, z. B. Edelstahl, einem Kunststoff, einer Keramik, einem Glas, z. B. einem technischen Glas, bestehen. Vorzugsweise besteht das zweite Trägerelement aus einem Leichtmetall oder einer Leichtmetalllegierung, besonders bevorzugt aus Aluminium oder einer Aluminiumlegierung. Vorzugsweise bestehen das erste Trägerelement und das zweite Trägerelement aus demselben Material.

Das erste und das zweite Trägerelement sind miteinander unter Ausbildung eines verbundenen Zustandes lösbar verbindbar. Zur lösbaren Verbindung des ersten Trägerelementes und des zweiten Trägerelementes können alle bekannten technischen Lösungen genutzt werden. Beispielsweise können das erste Trägerelement und zweite Trägerelement mittels einer Schraubverbindung, mittels eines Bajonettverschlusses oder mittels einer Magnetverbindung miteinander verbunden werden. Eine Magnetverbindung ist besonders bevorzugt. Um eine Magnetverbindung zwischen dem ersten Trägerelement und dem zweiten Trägerelement zu ermöglichen, können beide Trägerelemente Magnete aufweisen. Die Magnete können in den Trägerelementen oder an den Außenseiten der Trägerelemente angeordnet sein. Vorzugsweise sind Magnete an der Innenseite des ersten Trägerelementes und dazu korrespondierende Magnete an der Innenseite des zweiten Trägerelementes angeordnet. Dazu können Senkungen in der Innenseite des ersten Trägerelementes und der Innenseite des zweiten Trägerelementes ausgebildet sein. In die Senkungen sind die Magnete eingebracht. Die Senkungen an der Innenseite des zweiten Trägerelementes sind so ausgerichtet, dass sie im verbundenen Zustand geometrisch deckungsgleich zu den Senkungen an der Innenseite des ersten Trägerelementes liegen. Werden das erste und das zweite Trägerelement zur Herstellung des verbundenen Zustandes einander angenähert, so sorgt das von diesen Magneten ausgehende Magnetfeld für eine lagerichtige Positionierung des zweiten Trägerelementes an dem ersten Trägerelement. Das Magnetfeld hält die beiden Trägerelemente hinreichend gut zusammen. Die Belastung der Magnetverbindung ist dabei nicht hoch, weil das gehaltene Substrat flach ist und die beiden Trägerelemente ebenfalls flach ausgeführt sind, so dass die Masse der erfindungsgemäßen Trägervorrichtung vergleichsweise gering ist. Die Stärke der Magnetverbindung zwischen dem ersten und dem zweiten Trägerelement kann über die Zahl der Magneten bestimmt werden. Die Befestigung der Magnete an den Trägerelementen, beispielsweise in Senkungen, kann beispielsweise mittels Klebstoffs oder formschlüssig erfolgen. Die formschlüssige Befestigung kann beispielsweise durch Verformen des Materials, aus denen die Trägerelemente bestehen, z. B. durch Verstemmen, hergestellt werden. Die Magnete sind möglichst gleichmäßig über den umlaufend Rand des ersten Trägerelementes und den umlaufenden Rand des zweiten Trägerelementes verteilt. Dabei kann die geometrische Anordnung der Magnete der Geometrie des Substrates umlaufend und mit gleichmäßiger Verteilung folgen. Es kann vorgesehen sein, dass im verbundenen Zustand die Innenseiten des ersten Trägerelementes und des zweiten Trägerelementes formschlüssig aneinander anliegen.

Das erste Trägerelement weist einen unter Ausbildung einer ersten Substratöffnung umlaufenden Rahmen auf, der eine der ersten Substratöffnung zugewandte, d. h. innere Stirnseite besitzt. An der inneren Stirnseite ist ein Steg mit einer Oberseite ausgebildet, die einen Haltebereich für das Substrat bildet. Das Substrat liegt mit seiner Unterseite auf dem Haltebereich auf. Der Ausdruck "Oberseite" bezieht sich im Zusammenhang mit dem Steg auf die Seite des ersten Trägerelementes, auf der das Substrat mit seiner Unterseite aufliegt oder aufliegen soll. Das Substrat liegt nicht über die gesamte Fläche seiner Unterseite auf dem Haltebereich auf. Vielmehr ist vorgesehen, dass das Substrat nur mit einen Teil der Fläche seiner Unterseite auf dem Haltebereich aufliegen soll. Dieser Teil ist der Auflagebereich. Er grenzt an den Rand des Substrates an. Der Haltebereich läuft um die erste Substratöffnung um. Die Ausdehnung des Haltebereiches in Breitenrichtung des Rahmens hängt in Abhängigkeit von den Eigenschaften des Substrates sowie den Bearbeitungsverfahren ab, denen das gehaltene Substrat in einer Prozessanlage, insbesondere einer Druckprozessanlage, unterzogen werden soll. Bei Substraten, die eine hohe Steifigkeit aufweisen, kann die Breite des Haltebereiches beispielsweise kleiner als oder gleich 1 mm, vorzugsweise kleiner als oder gleich 0,9, 0,8, 0,7, 0,6, 0,5, 0,4, 0,3 oder 0,2 mm sein. Die Breite des Haltebereiches kann damit so bemessen sein, dass 99 % der Fläche der Unterseite des gehaltenen Substrates freiliegen. Die freiliegende Fläche ist für eine Bearbeitung zugänglich. Bei Substraten mit geringer Dicke, die aufgrund dessen eine geringe Steifigkeit aufweisen und/oder empfindlich beispielsweise gegen Bruch sind, kann die Breite des Halbebereiches auch größer als 1 mm sein. Sie kann derart breit sein, dass sie bis zu 50 % der Fläche der Unterseite des gehaltenen Substrates bedeckt.

Die Bereite des Haltebereiches kann jedoch auch unabhängig von Steifigkeit oder Dicke des Substrates so ausgebildet sein, dass er das Substrat nicht nur hält, sondern auch stützt. Dazu kann der Steg als Stützstruktur ausgebildet sein. Beispielsweise kann der Steg als Wabenstruktur ausgebildet sein. Ein Steg weist eine Stützstruktur auf, wenn in ihn durchgehende Öffnungen eingebracht sind, die sich von der Unterseite des Steges bis zu dessen Oberseite erstrecken. Der Haltbereich weist somit Öffnungen auf, so dass das Substrat im Auflagebereich teilweise freiliegt. Damit bildet ein Steg, der Öffnungen aufweist, eine Maske.

Die Ausbildung des Steges als Maske ermöglicht es, dass nur vorgegebene Bereiche der Unterseite des Substrates in einer Prozessanlage einer Bearbeitung unterzogen werden. Der am ersten Trägerelement ausgebildete Steg kann in Form einer Maske ausgebildet sein. Bereits ein Steg ohne Öffnungen bildet eine Maske, weil über die Breite des Stege bestimmt wird, welche Fläche der Unterseite des Substrates freiliegt und welche Fläche des Substrates den Auflagebereich bildet, mit dem das Substrat auf dem Haltebereich aufliegt. In diesem Fall bildet der Steg eine umlaufende Kontur. Sind Öffnungen in dem Steg ausgebildet, so bildet der Steg mit solchen Öffnungen eine Maske, die eine Bearbeitung der Unterseite des Substrates auch im Bereich der Öffnungen zulässt. Die Öffnungen können eine vorgegebene Anordnung aufweisen. Auf diese Weise kann eine Struktur erhalten werden, beispielsweise eine Wabenstruktur.

Ist der Steg als Maske ausgebildet, so wird das erste Trägerelement bei der Bearbeitung des gehaltenen Substrates stark belastet. Das erste Trägerelement ist dabei einem hohen Verschleiß unterworden. Es ist deshalb zweckmäßig, wenn das erste Trägerelement möglichst einfach und möglichst kostengünstig herzustellen ist. Im Gegensatz zum erste Trägerelement wird das zweite Trägerelement nicht in gleicher Weise belastet wie das erste Trägerelement, weil das erste Trägerelement das zweite Trägerelement schützt.

Der umlaufende Steg, der an der inneren Stirnseite des Rahmens des ersten Trägerelementes ausgebildet ist, erstreckt sich vorzugsweise von der Außenseite des Rahmens in Richtung der Innenseite des Trägerelementes. Dabei ist die Oberseite des Steges in Dickenrichtung versetzt zur Innenseite des Rahmens ausgebildet, so dass eine erste umlaufende Kante ausgebildet ist, die sich von der Innenseite des Rahmens bis zur Oberseite des Steges erstreckt. Die erste umlaufende Kante ist, bezogen auf die Breite des Rahmens, in Richtung der äußeren Stirnseite versetzt ausgebildet. Der Steg selbst weist eine zweite umlaufende Kante auf, die von der ersten umlaufenden Kante in Richtung der ersten Substratöffnung versetzt ist. Die erste umlaufende Kante begrenzt die Oberseite des Steges in Richtung der äußeren Stirnseite. Die zweite umlaufende Kante begrenzt die erste Substratöffnung, bezogen auf die Breitenrichtung des Rahmens. In der ersten Kante können Vertiefungen ausgebildet sein, um die Passform zwischen dem gehaltenen Substrat und dem ersten Trägerelement weiter zu verbessern.

Die erste Substratöffnung ist vorzugsweise so bemessen, dass das gehaltene Substrat auf dem Haltebereich aufliegen kann, ohne die erste umlaufende Kante des Rahmens des ersten Trägerelementes zu kontaktieren. Der Abstand zwischen den sich, bezogen auf den umlaufenden Rahmen, gegenüberliegenden Abschnitten der umlaufenden ersten Kante, ist somit größer als die Ausdehnung des gehaltenen Substrates. Die erste Substratöffnung und der am Rahmen umlaufende Haltebereich haben somit eine größere Ausdehnung als das gehaltene Substrat, bezogen auf die Flächenrichtung des gehaltenen Substrates. Auf diesem Grund kann ein umlaufender Spalt zwischen dem Rand des gehaltenen Substrates und der ersten umlaufenden Kante ausgebildet sein. Der umlaufende Spalt ermöglicht den Ausgleich von Toleranzen, die die Substrate in Flächenrichtung aufweisen können. Solche Toleranzen treten insbesondere bei unterschiedlichen Chargen an Substraten auf. Das Substrat wird vorzugsweise so in der erfindungsgemäßen Trägervorrichtung gehalten, dass es nur die Oberseite des umlaufenden Steges kontaktiert, aber nicht die erste umlaufende Kante.

Der Rahmen des zweiten Trägerelementes kann eine der zweiten Substratöffnung zugewandte, innere Stirnseite aufweisen, die im verbundenen Zustand versetzt zur zweiten umlaufenden Kante des Rahmens des ersten Trägerelementes verläuft. Die Stirnseite des Rahmens des zweiten Trägerelementes kann im verbundenen Zustand fluchtend zur ersten umlaufenden Kante des Rahmens des ersten Trägerelementes liegen. Zwischen der inneren Stirnseite und dem Rand des gehaltenen Substrates ist daher ein umlaufender Spalt ausgebildet, der im verbundenen Zustand in Dickenrichtung fluchtend zum Spalt zwischen der ersten umlaufenden Kante des Rahmens des erste Trägerelementes und dem gehaltenen Substrat verläuft. Die zweite Substratöffnung kann, bezogen auf die Breitenrichtung des Rahmens, eine größere Ausdehnung als die erste Substratöffnung haben. Die zweite Substratöffnung ist vorzugsweise so dimensioniert, dass das gehaltene Substrat das zweite Trägerelement nicht kontaktiert. Die innere Stirnseite des Rahmens des zweiten Trägerelementes kann abgerundet sein. In der inneren Stirnseite des Rahmens des zweite Trägerelementes können Vertiefungen ausgebildet sein, um die Passform zwischen dem gehaltenen Substrat und dem zweiten Trägerelement weiter zu verbessern.

Das erfindungsgemäß vorgesehene Klemmelement sorgt für einen sicheren Halt und eine sichere Lagefixierung des Substrates in der erfindungsgemäßen Trägervorrichtung im verbundenen Zustand. Das Klemmelement kann außerdem die Beaufschlagung des gehaltenen Substrates mit Prozesskräften, insbesondere während der Bearbeitung des gehaltenen Substrates in einer Prozessanlage, erleichtern. Das Klemmelement ist so ausgebildet, dass es das flache Substrat, wenn es im verbundenen Zustand mit einer Flächenseite auf dem Haltebereich aufliegt, an der Oberseite kontaktiert und gegen den Steg des ersten Trägerelementes presst. Das Klemmelement kann ein flacher Körper sein.

Die erfindungsgemäße Trägervorrichtung kann ein oder mehrere Klemmelemente aufweisen. Vorzugsweise ist nur ein Klemmelement vorgesehen. Dazu kann das Klemmelement einen umlaufenden Rahmen aufweisen, so dass eine dritte Substratöffnung ausgebildet ist. Die zweite Substratöffnung und die dritte Substratöffnung können fluchtend zueinander ausgerichtet sein.

Das Klemmelement kann eine Innenseite, eine Außenseite, eine Stirnseite, die im Folgenden auch als innere Stirnseite bezeichnet wird, und eine dieser Stirnseite gegenüberliegende Stirnseite, die im Folgenden als äußere Stirnseite bezeichnet wird, aufweisen. Die Ausdehnung zwischen seiner Innenseite und seiner Außenseite ist seine Dicke, die Ausdehnung orthogonal zur Dicke zwischen seinen beiden Stirnseiten seine Breite. Das Klemmelement liegt vorzugsweise mit seiner Innenseite auf der Außenseite des zweiten Trägerelementes an.

Das Klemmelement kann einen ersten Abschnitt und einen zweiten Abschnitt aufweisen, wobei der erste Abschnitt an der Außenseite des zweite Trägerelementes befestigt ist und der zweite Abschnitt, wenn das Substrat im verbundenen Zustand mit einer Flächenseite auf dem Haltebereich anliegt, an der anderen Flächenseite des Substrates anliegt. Der zweite Abschnitt kann eine Krümmung aufweisen. Bezogen auf die Oberseite des gehalten Substrates kann die Krümmung eine konkave Krümmung sein. Die Achse der Krümmung verläuft vorzugsweise orthogonal zur Dickenrichtung und orthogonal zur Breitenrichtung des Klemmelementes. Weist der zweite Abschnitt eine Krümmung auf, so kann vorgesehen sein, das er nur im Bereich des Scheitelpunktes der Krümmung die Oberseite des gehaltenen Substrates kontaktiert. Der erste Abschnitt kann in Dickenrichtung versetzt zum zweiten Abschnitt verlaufen. Der erste Abschnitt muss nicht unmittelbar in den zweiten Abschnitt übergehen. Das Klemmelement kann alternativ auch ein ebenes Element sein, also ein Element, das weder eine Krümmung noch einen Versatz aufweist.

Das Klemmelement kann aus einem elastisch verformbaren Material bestehen, so dass es eine Klemmwirkung erzielen kann. Beispielsweise kann das Klemmelement aus einem Federmaterial bestehen. Eine Federmaterial besitzt Federeigenschaften. Beispielsweise kann das Klemmelement aus Edelstahl oder Kunststoff bestehen. Das Klemmelement kann eine geringe Dicke aufweisen. Beispielsweise kann das Klemmelemente eine Dicke aufweisen, die kleiner als oder gleich 1 mm, vorzugsweise kleiner als oder gleich 0,9, 0,8, 0,7, 0,6, 0,5, 0,4, 0,3 oder 0,2 mm ist. Das Klemmelement ist an der Außenseite des zweiten Trägerelementes befestigt. Die Ausbildung des Klemmelementes aus einem Federmaterial mit geringer Dicke ermöglicht eine gute Beweglichkeit des Klemmelementes, insbesondere des zweiten Abschnittes des Klemmelementes. Die Kraft, welche das Klemmelement auf das gehaltene Substrat ausübt, kann auf einfache Weise durch Variation der Materialdicke des Klemmelementes eingestellt werden.

Ist das Klemmelement ein ebenes Element, so kann es beispielsweise aus einer Folie gebildet sein. Das Klemmelement kann dann aus der Folie durch Zuschneiden hergestellt werden. Im Hinblick auf die Dicke des zweiten Trägerelementes ist allerdings ein Zuschneiden der Folie zur Bildung des Klemmelementes bei vergleichsweise dünnen Substraten nicht bevorzugt, weil in diesem Fall die Schnittkante, die der dritten Substratöffnung zugewandt ist, scharfkantig sein kann. Der Kontakt zwischen der Oberseite des Substrates und einer scharfkantigen Schnittkante könnte unter ungünstigen Umständen zur Beschädigung des Substrates führen.

Weist das Klemmelement jedoch einen gekrümmten zweiten Abschnitt und/oder einen Versatz zwischen dem ersten Abschnitt und dem zweiten Abschnitt in Dickenrichtung auf, so kann eine substratschonende Kontaktstelle zwischen dem Klemmelement und dem gehaltenen Substrat erreicht werden. Ein gekrümmter zweiter Abschnitt ist besonders vorteilhaft, weil das Klemmelement in diesem Fall nur am Scheitelpunkt der Krümmung des zweiten Abschnittes die Oberseite des gehaltenen Substrates kontaktiert, d. h. mit einer Rundung und nicht, wie im Fall des ebenen Klemmelementes mit einer scharfen Kante.

Es ist allerdings zu berücksichtigen, dass die zur Ausbildung des Versatzes zwischen dem ersten und dem zweiten Abschnitt des Klemmelementes und/oder die Ausbildung einer Krümmung eine Materialverformung bei der Herstellung des Klemmelementes erforderlich ist. Die Materialverformung kann, insbesondere wenn das Klemmelement einen umlaufenden Rahmen aufweist, also eine vollkommen geschlossene Geometrie besitzt, zu einer enorm hohen Aussteifung des Klemmelementes führen. Eine solche Versteifung könnte die Klemmeigenschaften des Klemmelementes beeinträchtigen. Es kann daher vorgesehen sein, dass das Klemmelement einen oder mehrere Ausschnitte aufweist, wobei die Ausschnitte an einer Stirnseite des Klemmelementes, d. h. der inneren Stirnseite, ausgebildet sind, die der dritten Substratöffnung zugewandt ist. Die Ausschnitte erstrecken sich vorzugsweise von der Innenseite des Klemmelementes zu dessen Außenseite und von der inneren Stirnseite in Richtung der äußeren Stirnseite des Klemmelementes. Vorzugsweise ist die Ausdehnung der Ausschnitte schmaler als die Ausdehnung der zwischen diesen Ausschnitten liegenden Bereiche des Klemmelementes. Weist das Klemmelement einen Rahmen auf, so ist die Ausdehnung der Ausschnitte in Umlaufrichtung des Rahmens geringer als die Ausdehnung der zwischen diesen Ausschnitten liegenden Bereiche des Klemmelementes. Die zwischen den Ausschnitten liegenden Bereiche können jeweils separat voneinander eine Klemmwirkung auf das gehaltene Substrat ausüben, d. h. sie wirken wie einzelne Klemmelemente.

Die Ausschnitte erstrecken sich vorzugsweise nicht von der inneren Stirnseite bis zur äußeren Stirnseite des Klemmelementes. Damit sind die Bereiche, die zwischen den Ausschnitten liegen, an der äußeren Stirnseite des Klemmelementes miteinander verbunden. Das erleichtert die Handhabung des Klemmelementes bei der Einbringen oder Entnahme eines Substrates aus der erfindungsgemäßen Trägervorrichtung.

Das Klemmelement kann an der Außenseite des zweiten Trägerelementes befestigt sein. Zur Befestigung des Klemmelementes an dem zweiten Trägerelement können alle bekannten technischen Lösungen genutzt werden. Beispielsweise können das Klemmelement und das zweite Trägerelement mittels einer Schraubverbindung, mittels einer Klebverbindung oder mittels einer stoffschlüssigen Verbindung miteinander verbunden sein. Eine stoffschlüssige Verbindung, beispielsweise eine Schweißverbindung, ist bevorzugt, weil eine solche Verbindung haltbar und platzsparend ist. Eine Schweißverbindung kann beispielsweise mittels Punktschweißens hergestellt werden.

Die erfindungsgemäße Trägervorrichtung kann Positionierstifte für die Positionierung des zweiten Trägerelementes an dem ersten Trägerelement aufweisen. Dabei kann vorgesehen sein, dass an der Innenseite des ersten Trägerelementes Positionsbohrungen ausgebildet sind und an der Innenseite des zweiten Trägerelementes die Positionierstifte angeordnet sind. Zur Herstellung des verbundenen Zustandes werden die Positionierstifte des zweiten Trägerelementes in die Positionsbohrungen des ersten Trägerelementes eingeführt, wodurch eine Positionierung des zweiten Trägerelementes am ersten Trägerelement erreicht wird.

Es kann vorgesehen sein, dass an dem ersten Trägerelement eine oder mehrere Ausklinkungen ausgebildet sind. Es kann ferner vorgesehen sein, dass an dem zweiten Trägerelement eine oder mehrere Ausklinkungen ausgebildet sind. Die Ausklinkungen können das Einbringen in die und das Entnehmen eines Substrates aus der erfindungsgemäßen Trägervorrichtung mittels angepasster Werkzeuge erleichtern. Das gilt insbesondere für ein manuelles Einbringen oder manuelles Entnehmen.

Die erfindungsgemäße Trägervorrichtung soll die Bearbeitung des von ihm gehaltenen Substrates ermöglichen, insbesondere die Bearbeitung in Druckprozessanlagen. Bei der Bearbeitung der Substrate unter Überdruck oder Unterdruck spielen zumeist thermische Einflüsse eine Rolle. Die erfindungsgemäße Trägervorrichtung sollte somit einen möglichst geringen thermischen Einfluss haben. Es kann daher vorgesehen sein, dass die Ausdehnung des Rahmens des ersten Trägerelementes in Breitenrichtung geringer als die Ausdehnung Rahmens des zweiten Trägerelementes ist. Es kann ferner vorgesehen sein, dass der Rahmen des zweiten Trägerelementes einen ersten Abschnitt und einen zweiten Abschnitt aufweist. Der erste Abschnitt erstreckt sich in Breitenrichtung von der inneren Stirnseite in Richtung der äußeren Stirnseite des Rahmens, während sich der zweite Abschnitt in Breitenrichtung von der äußeren Stirnseite in Richtung der inneren Stirnseite des Rahmens erstreckt. Zwischen dem ersten Abschnitt und dem zweiten Abschnitt liegt eine Grenzfläche, die sich in Dickenrichtung und Umfangsrichtung des Rahmens erstreckt. Es kann nun vorgesehen sein, das sich der erste Abschnitt von der Grenzfläche in Richtung der inneren Stirnseite des Rahmens verjüngt. Der erste Abschnitt besitzt an der inneren Stirnseite des Rahmens eine geringere Dicke als an der Grenzfläche, in der er die Dicke des zweiten Abschnittes besitzt. Auf diese Weise wird eine erfindungsgemäße Trägervorrichtung mit schlanker Geometrie erhalten. Die Trägervorrichtung verläuft in einem flachen Winkel, bezogen auf die Flächenrichtung des gehaltenen Substrates. Lediglich an seiner Stirnseite, die in der Regel weniger als 1 % seiner Oberfläche ausmacht, kann ein thermischer Einfluss nicht vollkommen ausgeschlossen werden. Dieser Einfluss kann jedoch weiter minimiert werden, wenn das zweite Trägerelement in einem Bearbeitungsprozess mittels einer oder mehrerer Temperierungseinrichtungen unmittelbar kontaktiert wird.

Das zweite Trägerelement kann eine Greifstelle zum Eingriff eines Fingers einer Handhabeeinrichtung aufweisen. Vorzugsweise ist die Greifstelle an einer äußeren Stirnseite des Rahmens des zweiten Trägerelementes ausgebildet. Weist der Rahmen des ersten Trägerelementes eine geringere Breite auf als der Rahmen des zweiten Trägerelementes, so bedeckt die Innenseite des Rahmens des erste Trägerelement die Innenseite des Rahmens des zweiten Trägerelementes nicht vollständig. Vielmehr bedeckt sie nur einen Bereich der Innenseite, der an die innere Stirnseite des Rahmens des zweite Trägerelementes angrenzt, während die Innenseite in einem Bereich, der an die äußere Stirnseite des Rahmens des zweite Trägerelementes angrenzt, freiliegt. Die Greifstelle, die am Rahmen des zweiten Trägerelementes ausgebildet ist, kann in diesem freiliegenden Bereich ausgebildet sein. An der Greifstelle kann ein Formelement ausgebildet sein, in das ein korrespondierendes Formelement, das an dem Finger der Handhabevorrichtung ausgebildet ist, unter Herstellung eines Formschlusses eingreifen kann. Das Formelement der Greifstelle kann zur Positionierung des Fingers an der Greifstelle dienen, so dass sich das zweite Trägerelement - und im verbundenen Zustand die gesamte Trägervorrichtung - in definierter Lage zum Finger befindet, wenn die Handhabevorrichtung des zweiten Trägerelementes mittels des Fingers greift. Die Formelemente stellen somit Positionierungselemente dar.

Es kann vorgesehen sein, dass an der Innenseite oder an der Außenseite des Rahmens des zweiten Trägerelementes eine oder mehrere Nuten, beispielsweise eine oder mehrere C-Nuten, ausgebildet sind. Vorzugsweise sind die Nut oder die Nuten an der Innenseite, besonders bevorzugt im freiliegenden Bereich der Innenseite, ausgebildet. In diese Nuten können Spannköpfe eingeführt werden, mit denen die erfindungsgemäße Trägervorrichtung im verbundenen Zustand in einer vorgegebenen Position fixiert werden kann. Eine solche Fixierung ist bei der Bearbeitung, insbesondere bei der Bearbeitung unter Über- oder Unterdruck, häufig vorteilhaft. Mittels der Spannköpfe kann die erfindungsgemäße Trägervorrichtung im verbundenen Zustand gegen ein Widerlager bewegt, beispielsweise nach oben oder unten, und damit fixiert werden. Die Spannköpfe können Teil einer Handhabevorrichtung sein. Das gilt ebenso für das Widerlager. Eine solche Bewegung und Fixierung ist insbesondere in einer Prozessstation einer Prozessanlage von Vorteil. Die Nuten können Längsnuten oder in Umfangsrichtung des Rahmens umlaufende Nuten sein. Die Längsnut beginnt bevorzugt an der äußeren Stirnseite des Rahmens. Auf diese Weise ist die Einführung eines Spannkopfes in die Nut in einfacher Weise möglich. Besonders bevorzugt beginnt die Längsnut an der äußeren Stirnseite und endet an der äußeren Stirnseite. Vorzugsweise sind zwei zueinander parallele Längsnuten vorgesehen. Bei einer umlaufenden Nut können Öffnungen vorgesehen sein, in denen die Spannköpfe in die Nut von unten, bezogen auf die Nut, eintauchen können.

Das Widerlager kann als thermische Komponente, beispielsweise als Temperierungseinrichtung, ausgelegt sein. Wird das zweite Trägerelement mit einem solchen Widerlager in Kontakt gebracht, so kann die erfindungsgemäße Trägervorrichtung in der fixierten Position der Prozessstation temperiert werden. Alternativ können eine oder mehrere thermische Komponenten auch aktiv an das zweite Trägerelement herangeführt werden, beispielsweise an seine äußere Stirnseite, seine Außenseite und/oder seine Innenseite.

Das gehaltene Substrat liegt an seiner Unterseite im Bereich der ersten Substratöffnung frei. An seiner Oberseite kann es im Bereich der zweiten und dritten Substratöffnung freiliegen. Es kann daher vorgesehen, dass das gehaltene Substrat während seiner Bearbeitung in der Prozessanlage mit seiner Unterseite unmittelbar auf einem Prozesselement aufliegt. Dazu kann eine Bearbeitungsvorrichtung vorgesehen sein, die das Prozesselement aufweist. Mittels der Handhabevorrichtung kann die Trägervorrichtung so positioniert werden, dass das von ihr gehaltene Substrat mit seiner Unterseite auf dem Prozesselement aufliegt und damit direkt kontaktiert wird. Eine solche Fixierung des gehaltenen Substrates ist besonders vorteilhaft. Für eine solche Fixierung kann folgendermaßen vorgegangen werden: Mittels des Fingers der Handhabevorrichtung wird die Trägervorrichtung mit dem gehaltenen Substrat auf dem Prozesselement abgelegt, so dass das Substrat in direkten Kontakt mit dem Prozesselement kommt. Anschließend werden die Spannköpfe gegen das Prozesselement bewegt, so dass das Substrat mit einer Kraft F2, die vom Klemmelement auf die Oberseite des Substrates übertragen wird, auf das Prozesselement geklemmt wird. Die Kraft F2 resultiert aus der Kraft F1, die die Bewegung der Spannköpfe auf das zweite Trägerelement ausübt. Die Kraft F2 sorgt dafür, dass das Substrat mit einer Kraft F3 gegen das Prozesselement gepresst wird. Das Klemmelement sorgt für eine gleichmäßige Verteilung der Kraft am Substrat. Eine gleichmäßige Verteilung kann insbesondere über die zwischen den Ausschnitten liegenden Bereiche erreicht werden. Über die Materialdicke des Klemmelementes kann die Kraft F2 eingestellt werden, die das Klemmelement während der Bearbeitung auf das Substrat ausübt.

Es ist möglich, ein Substrat manuell oder automatisiert in die erfindungsgemäße Trägervorrichtung einzulegen oder aus der Trägervorrichtung zu entnehmen. Manuelles Einlegen und Entnehmen ist insbesondere in der Forschung und in einer Produktion im kleinen Maßstab üblich. Das Einlegen des Substrates in die erfindungsgemäße Trägervorrichtung wird im Folgenden auch als Beladung, das Entnehmen des Substrates aus der erfindungsgemäßen Trägervorrichtung wird im Folgenden auch als Entladung bezeichnet.

Eine automatisierte Be- und Entladung bietet gegenüber der manuellen Be- und Entladung Vorteile. In einer Druckprozessanlage muss die Trägervorrichtung nicht auf die Umgebungsbedingungen, d. h. in der Regel atmosphärischen Bedingungen, gebracht werden. Das ist insbesondere vorteilhaft für Beschichtungsprozesse, bei denen das erste Trägerelement einen als Maske ausgebildeten Steg aufweist. Es ist ferner besonders vorteilhaft für alle Arten von Prozessen, bei denen die thermischen Bedingungen eine Rolle spielen. Bei solchen Prozessen kann die Be- und Entladung bei von der Umgebungstemperatur, das ist in der Regel die Raumtemperatur, abweichenden Temperaturen erfolgen, was energetisch und zeitlich günstig ist.

Im einfachsten Fall wird zur Beladung der Trägervorrichtung mit einem Substrat das zweite Trägerelement von dem ersten Trägerelement abgenommen, wenn dies nicht bereits der Fall ist. Das Substrat wird mit seiner Unterseite auf den Steg des ersten Trägerelementes aufgelegt, so dass es mit seinem Auflagebereich auf dem Haltebereich aufliegt und dort gehalten wird. Anschließend wird das zweite Trägerelement auf das erste Trägerelement aufgelegt, so dass die Innenseiten der Rahmen der beiden Trägerelemente aneinander anliegen. Die beiden Trägerelemente werden miteinander verbunden, wodurch der verbundene Zustand der Trägervorrichtung hergestellt wird. Dabei presst das Klemmelement das Substrat gegen den Steg. Zur Entladung wird die Verbindung zwischen dem ersten und dem zweiten Trägerelement gelöst, das zweite Trägerelement vom ersten Trägerelement abgenommen und schließlich das Substrat aus dem ersten Trägerelement entnommen.

Zur Be- und Entladung kann eine erste Ladevorrichtung vorgesehen sein. Die erste Ladevorrichtung ist insbesondere zum manuellen Be- und Entladen geeignet. Die erste Ladevorrichtung weist eine Auflage auf, auf der die Trägervorrichtung mit der Außenseite des ersten Trägerelementes aufliegen kann, so dass die erste Substratöffnung freiliegt und sich annähernd in einer horizontalen Ebene erstreckt. Ein Bediener kann die Trägervorrichtung im verbundenen Zustand in die erste Ladevorrichtung einlegen, so dass sie mit der Außenseite des ersten Trägerelementes auf der Auflage aufliegt. Vorzugsweise legt der Bediener die Trägervorrichtung mittels einer horizontalen Schubbewegung, beispielsweise parallel zu den C-Nuten in dem zweiten Trägerelement, in die erste Ladevorrichtung ein. Die erste Ladevorrichtung kann eine oder mehrere Fixierungselemente, vorzugsweise zwei Fixierungselemente, aufweisen. Bei den Fixierungselementen kann es sich um Klemmleisten handeln. Vorzugsweise sind die Fixierungselemente so ausgebildet, dass sie den Rahmen des ersten Trägerelementes an dessen äußerer Stirnseite und einen daran angrenzenden Bereich der Innenseite umschließen, vorzugsweise unter Ausbildung eines Spaltes zwischen dem Fixierungselement und dem Rahmen. Um die Aufbringung des zweiten Trägerelementes auf das erste Trägerelement zu erleichtern, können an der Innenseite des zweiten Trägerelementes eine oder mehrere Ausnehmungen für das oder die Fixierungselemente ausgebildet sein, so dass der Rahmen des zweiten Trägerelements mit seiner Innenseite an der Innenseite des Rahmens des ersten Trägerelementes anliegen kann, ohne von dem oder den Fixierungselementen behindert zu werden. Der Bediener veranlasst die Fixierung des ersten Trägerelementes mit dem oder den Fixierungselementen. Sofern erforderlich, wird die mittels Verbindungsmitteln hergestellte Verbindung zwischen den beiden Trägerelementen gelöst.

Der Bediener kann das zweite Trägerelement anheben und damit von dem ersten Trägerelement entfernen, das währenddessen von dem oder den Fixierungselementen gehalten wird. Sollte ein Substrat auf dem Steg des ersten Trägerelementes aufliegen, so kann dieses nun vom Bediener auf dem ersten Trägerelement entnommen werden. Das ist der Entladevorgang. Ausklinkungen am ersten Trägerelement erleichtern dem Bediener mit geeigneten, technisch bekannten Werkzeugen die Entnahme des Substrates. Ist das Substrat entnommen worden oder lag ohnehin kein Substrat in der Trägervorrichtung, so kann nun ein anderes Substrat in das erste Trägerelement eingelegt werden, so dass es mit seinem Auflagebereich auf dem Haltebereich aufliegt. Anschließend kann der Bediener das zweite Trägerelement wieder auf das erste Trägerelement auflegen, d.h. die Innenseite des Rahmens des zweiten Trägerelementes auf der Innenseite des Rahmens des ersten Trägerelementes aufbringen. Die Positionierstifte und korrespondierenden Positionsbohrungen können die positionsgenaue Positionierung des zweiten Trägerelementes an dem ersten Trägerelement erleichtern. Damit befindet sich die Trägervorrichtung im verbundenen Zustand. Sofern erforderlich, wird die Verbindung mittels der Verbindungsmittel hergestellt. Das ist die Beladung. Der Bediener kann die Fixierungselemente von dem ersten Trägerelement lösen und anschließend die Trägervorrichtung aus der ersten Ladevorrichtung entnehmen.

Zur Be- und Entladung kann alternativ eine zweite Ladevorrichtung vorgesehen sein. Die erste Ladevorrichtung ist insbesondere zum automatisierten Be- und Entladen geeignet. Die zweite Ladevorrichtung kann eine automatisierte Trägervorrichtungs-Wechselstation sein, die Teil einer Prozessanlage, insbesondere einer Druckprozessanlage, ist.

Mittels der erfindungsgemäßen Handhabevorrichtung wird eine erfindungsgemäße Trägervorrichtung im verbundenen Zustand in die zweite Ladevorrichtung eingelegt, vorzugsweise durch eine horizontale Schubbewegung parallel zu den Nuten im zweiten Trägerelement. Die zweite Ladevorrichtung weist eine Basisauflage auf, auf der die Trägervorrichtung mit der Außenseite des ersten Trägerelementes aufliegen kann, so dass die erste Substratöffnung freiliegt und sich annähernd in einer horizontalen Ebene erstreckt. Die Handhabevorrichtung kann die Trägervorrichtung im verbundenen Zustand in die zweite Ladevorrichtung einlegen, so dass sie mit der Außenseite des ersten Trägerelementes auf der Basisauflage aufliegt. Vorzugsweise legt die Handhabevorrichtung die Trägervorrichtung mittels einer horizontalen Schubbewegung, beispielsweise parallel zu den C-Nuten in dem zweiten Trägerelement, in die zweite Ladevorrichtung ein. Die zweite Ladevorrichtung kann ein oder mehrere Fixierungselemente, vorzugsweise zwei Fixierungselemente, aufweisen. Bei den Fixierungselementen kann es sich um Klemmleisten handeln. Vorzugsweise sind die Fixierungselemente so ausgebildet, dass sie den Rahmen des ersten Trägerelementes an dessen äußerer Stirnseite und einen daran angrenzenden Bereich der Innenseite umschließen, vorzugsweise unter Ausbildung eines Spaltes zwischen dem Fixierungselement und dem Rahmen. Um die Aufbringung des zweiten Trägerelementes auf das erste Trägerelement zu erleichtern, können an der Innenseite des zweiten Trägerelementes eine oder mehrere Ausnehmungen für das oder die Fixierungselemente ausgebildet sein, so dass der Rahmen des zweiten Trägerelements mit seiner Innenseite an der Innenseite des Rahmens des ersten Trägerelementes anliegen kann, ohne von dem oder den Fixierungselementen behindert zu werden. Optional können zusätzlich einer oder mehrere der Spannköpfe in der zweiten Ladevorrichtung zur Fixierung der Trägervorrichtung auf dem Basiselement vorgesehen sein. Dazu können der oder die Spannköpfe in die Nuten eingreifen, die an dem zweiten Trägerelement ausgebildet sind. Die Fixierung des ersten Trägerelementes mit dem oder den Fixierungselementen und, falls vorgesehen, dem oder den Spannköpfen, erfolgt automatisch, sobald die Handhabevorrichtung die Trägervorrichtung auf die Basisauflage aufgelegt hat. Sofern erforderlich, wird die mittels Verbindungsmitteln hergestellte Verbindung zwischen den beiden Trägerelementen gelöst.

Die Trägervorrichtung wird nun in zwei Stufen durch Ausführung einer Hubbewegung angehoben. Dazu weist die zweite Ladevorrichtung Hubelemente auf. Ein erstes Hubelement befindet sich in Kontakt mit der Unterseite des Substrates, ein zweites Hubelement mit dem freiliegenden Bereich der Innenseite des zweiten Trägerelementes. Durch eine synchrone Hubbewegung mittels dem ersten und zweiten Hubelement werden das Substrat und das zweite Trägerelement in eine erste Höhe H1 angehoben, während das erste Trägerelement mittels der Fixierungselemente in der Ausgangshöhe H0 gehalten wird. Damit sind das Substrat und das zweite Trägerelement vom ersten Trägerelement gelöst. Das ist die erste Stufe. In der zweiten Stufe wird nun das zweite Trägerelement mittels des zweiten Hubelementes auf eine zweite Höhe H2 angehoben. Das auf dem ersten Hubelement aufliegende Substrat liegt nun frei und kann mittels eines zweiten Fingers aus der Handhabevorrichtung aus der zweite Ladevorrichtung entnommen werden. Das ist die Entladung.

In die Trägervorrichtung kann nun ein neues Substrat eingelegt werden. Dabei wird das Substrat mit seiner Unterseite auf das erste Hubelement aufgelegt. Die Trägervorrichtung wird nun mittels der zweiten Ladevorrichtung wieder über zwei Höhen in den verbundenen Zustand überführt. Zunächst wird das zweite Trägerelement mittels des zweiten Hubelementes wieder aus der Höhe H2 in die Höhe H1 abgesenkt. Dabei umschließt das zweite Trägerelement das Substrat, wobei das Klemmelement in Kontakt mit der Oberseite des Substrates gelangt. Alternativ kann ein Spalt zwischen dem Klemmelement und der Oberseite des Substrates belassen werden. Der Spalt kann später geschlossen werden , was aber nicht erforderlich ist. Anschließend werden das Substrat mit dem ersten Hubelement und das zweite Trägerelement mit dem zweiten Hubelement synchron in die Ausgangsposition H0 abgesenkt. Das zweite Trägerelement liegt nun mit der Innenseite seines Rahmens auf der Innenseite des Rahmens des ersten Trägerelementes auf. Die Trägervorrichtung befindet sich nun im verbunden Zustand. Sofern erforderlich, wird die Verbindung mittels der Verbindungsmittel hergestellt. Das ist der Beladevorgang. Die Fixierungselemente und gegebenenfalls die Spannköpfe können nun von dem ersten Trägerelement gelöst werden. Mittels der Handhabevorrichtung kann die Trägervorrichtung nun aus der zweiten Ladevorrichtung entnommen werden.

Nach Maßgabe der Erfindung ist ferner eine Handhabevorrichtung für eine erfindungsgemäße Trägervorrichtung vorgehen, wobei die Handhabevorrichtung einen Finger zum Eingriff in eine Greifstelle aufweist, die an dem zweiten Trägerelement ausgebildet ist. Vorzugsweise weist der Finger zumindest ein Positionierungselement zum Zusammenwirken mit einem korrespondierten Positionierungselement auf, das an dem zweiten Trägerelement ausgebildet ist. Die Handhabeeinrichtung kann ferner einen oder mehrere Spannköpfe zur Fixierung der Trägervorrichtung, die sich im verbunden Zustand befindet, in der vorgegebenen Position aufweisen. Die Spannköpfe können in Nuten eingreifen, die am Rahmen des zweiten Trägerelementes ausgebildet sind. Die Handhabevorrichtung kann ferner ein Widerlager aufweisen, gegen die die Spannköpfe bewegt werden können. Weitere Einzelheiten der erfindungsgemäßen Handhabevorrichtung sind vorstehend im Zusammenhang mit der erfindungsgemäßen Trägervorrichtung beschrieben.

Die erfindungsgemäße Handhabungsvorrichtung ermöglicht auf einfache Weise eine prozesssichere Bewegung und Positionierung der erfindungsgemäßen Trägervorrichtung auch in abgeschlossenen Räumen.

Die Erfindung wird nachstehend anhand von Ausführungsbeispielen, die die Erfindung nicht einschränken sollen, unter Bezugnahme auf die Zeichnungen näher erläutert. Dabei zeigen
- Fig. 1: eine schematische Darstellung eines flachen Substrates (Fig. 1a: perspektivische Darstellung; Fig. 1b: Ansicht von unten);
- Fig. 2: vereinfachte Darstellungen einer Ausführungsform eines ersten Trägerelementes (Fig. 2a: Ansicht von oben; Fig. 2b: Schnittdarstellung; Fig. 2c: vergrößerte Darstellung des Ausschnittes I von Fig. 2b);
- Fig. 3: vereinfachte Darstellungen einer Ausführungsform eines zweiten Trägerelementes (Fig. 3a: Ansicht von oben; Fig. 3b: Schnittdarstellung; Fig. 1c: vergrößerte Darstellung des Ausschnittes II von Fig. 3b);
- Fig. 4: vereinfachte Darstellungen einer Ausführungsform eines Klemmelementes (Fig. 4a: Ansicht von oben; Fig. 4b: Schnittdarstellung; Fig. 4c: vergrößerte Darstellung des Ausschnittes I von Fig. 4b);
- Fig. 5: vereinfachte Darstellungen einer ersten Ausführungsform einer erfindungsgemäßen Trägervorrichtung (Fig. 5a: Schnitt in Dickenrichtung); Fig. 5b: vergrößerte Darstellung des Ausschnittes IV von Fig. 5a)
- Fig. 6: eine schematische Draufsicht auf die Außenseite einer Ausführungsform eines Klemmelementes;
- Fig. 7: eine schematische Schnittdarstellung einer weiteren Ausführungsform eines ersten Trägerelementes;
- Fig. 8: eine schematische Schnittdarstellung einer noch weiteren Ausführungsform eines ersten Trägerelementes;
- Fig. 9: eine schematische Schnittdarstellung einer zweiten Ausführungsform einer erfindungsgemäßen Trägervorrichtung;
- Fig. 10: schematische Darstellungen des Zusammenwirkens der zweiten Ausführungsform der erfindungsgemäßen Trägervorrichtung mit einer Ladevorrichtung;
- Fig. 11: eine schematische Darstellung einer Vorrichtung zur Bearbeitung flacher Substrate; und
- Fig. 12: vereinfachte Darstellungen einer Ausführungsform eines zweiten Trägerelementes (Fig. 12a: Ansicht von unten; Fig. 12b: Schnittdarstellung).

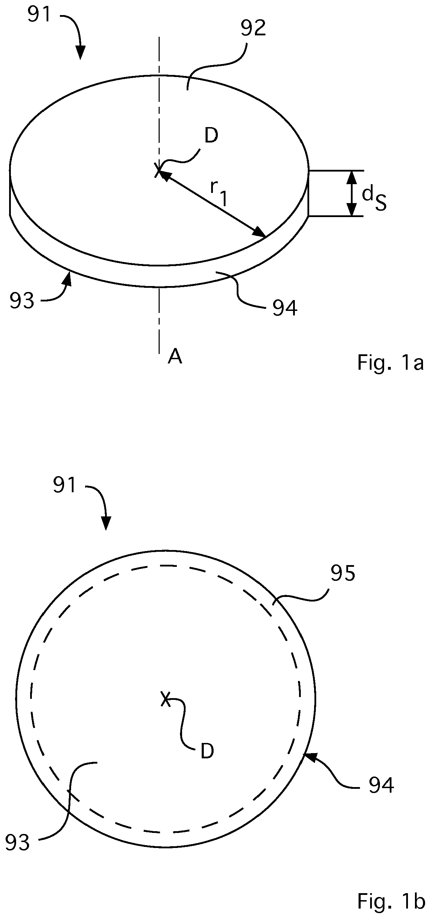

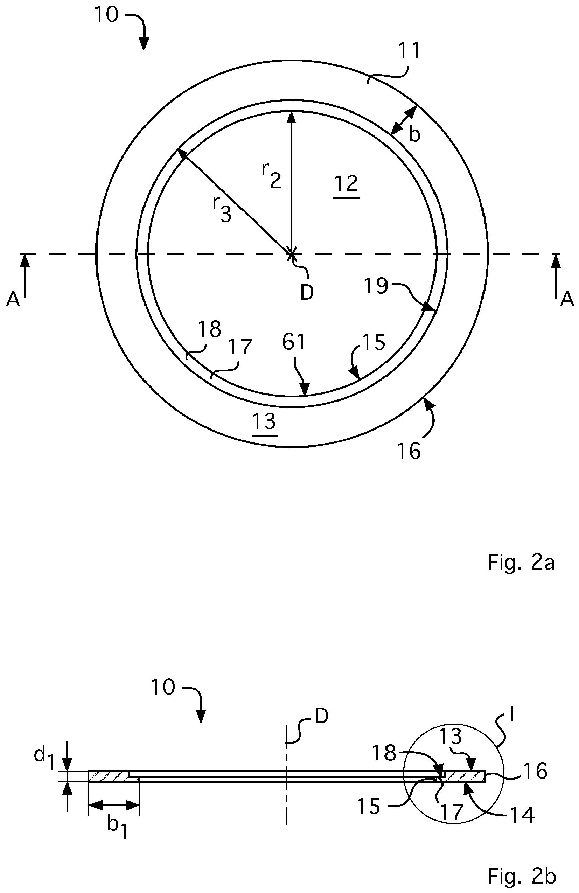

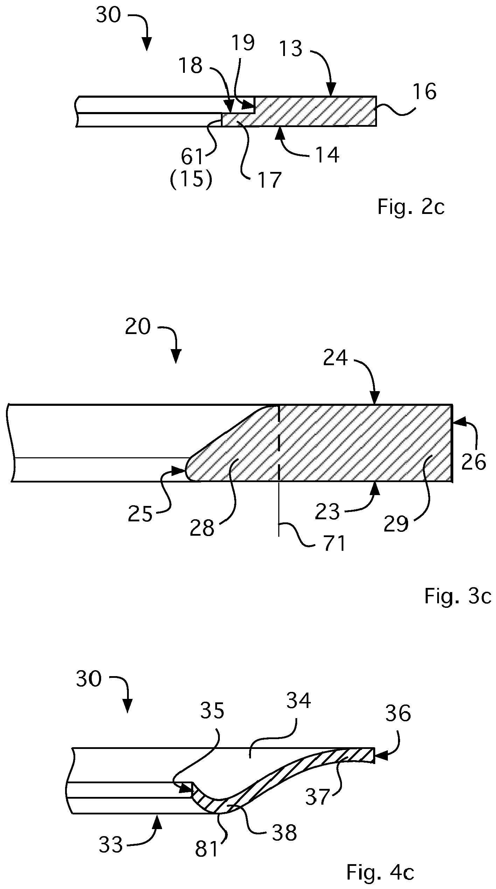

Die in den Figuren 2 bis 6 gezeigte Ausführungsform einer erfindungsgemäßen Trägervorrichtung 1 ist zum Halten eines flachen Substrates 91, beispielsweise eines Silicium-Wafers, bestimmt. Das Substrat 91 besitzt eine Oberseite 92, einen Unterseite 93 und einen Rand 94 (siehe Fig. 1). Die Oberseite 92 und die Unterseite 93 sind Kreisflächen, die parallel zueinander unter Ausbildung der umlaufenden Kante 94 verlaufen. Der Abstand zwischen der Oberseite 92 und der Unterseite 93 ist seine Dicke d_{S}. Das Substrat besitzt einen Radius r₁.

Die Trägervorrichtung 1 weist ein erstes Trägerelement 10, ein zweites Trägerelement 20 und ein Klemmelement 30 auf.

Das in den Figuren 2a bis 2c gezeigte erste Trägerelement 10 besitzt einen umlaufenden Rahmen 11, der eine erste Substratöffnung 12 mit kreisförmigem Querschnitt umgrenzt. Der Rahmen 11 besitzt eine Innenseite 13, eine Außenseite 14, eine umlaufende innere Stirnseite 15, die der ersten Substratöffnung 12 zugewandt ist, und eine umlaufende äußere Stirnseite 16, die der ersten Substratöffnung 12 abgewandt ist. Der Abstand zwischen der Innenseite 13 und der Außenseite 14 ist seine Dicke d₁, der Abstand zwischen den beiden Stirnseiten 15, 16 orthogonal zur Dickenrichtung ist seine Breite b₁. An der inneren Stirnseite 15 ist ein Steg 17 ausgebildet. Der Steg 17 weist eine Oberseite 18 auf, die den Haltebereich für das Substrat 91 bildet. Die Oberseite 18 wird durch eine umlaufende erste Kante 19 und eine umlaufende zweite Kante 61 begrenzt (siehe Fig. 2c), wobei die zweite Kante 61 der ersten Substratöffnung 12 zugewandt ist und die erste Kante 19 in Richtung der äußeren Stirnseite 16 versetzt ist. Auf der Oberseite 18 liegt das Substrat 91 mit einem umlaufenden Auflagebereich 95 auf, der an der Unterseite 93 an den Rand 94 angrenzt. Die erste Substratöffnung 12 wird durch die zweite umlaufende Kante 61 begrenzt. Der Radius r₂ der erste Substratöffnung ist kleiner als der Radius r₁ des Substrates 91. Der Radius r₃ der Öffnung, die von der ersten umlaufenden Kante 19 begrenzt wird, ist größer als der Radius r₁ des Substrates 91.

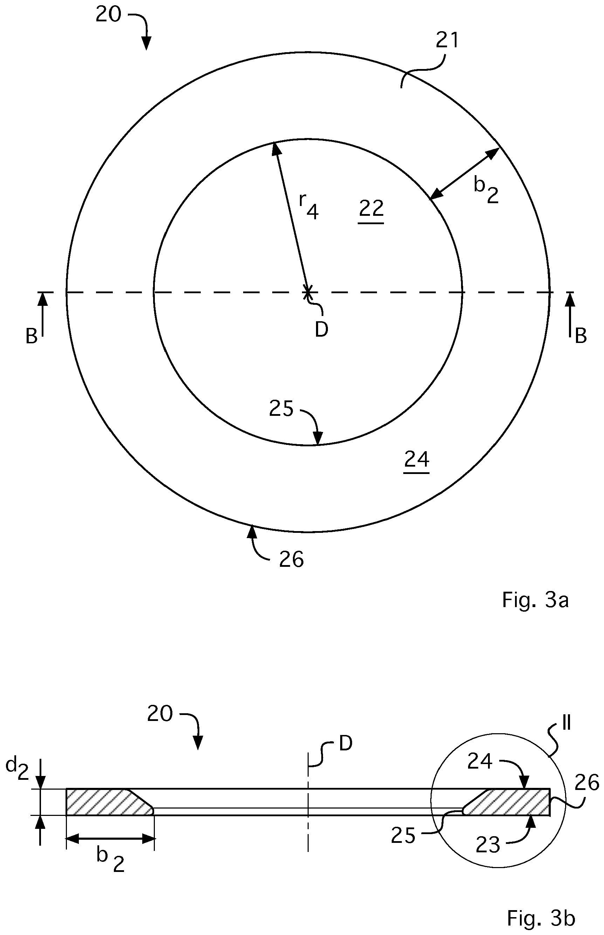

Das in den Figuren 3a bis 3c gezeigte zweite Trägerelement 20 besitzt einen umlaufenden Rahmen 21, der eine zweite Substratöffnung 22 mit kreisförmigem Querschnitt umgrenzt. Der Rahmen besitzt eine Innenseite 23, eine Außenseite 24, eine umlaufende und abgrundente innere Stirnseite 25, die der zweiten Substratöffnung 22 zugewandt ist, und eine umlaufende äußere Stirnseite 26, die der zweiten Substratöffnung 22 abgewandt ist. Der Abstand zwischen der Innenseite 23 und der Außenseite 24 ist seine Dicke d₂, der Abstand zwischen den beiden Stirnseiten 25, 26 orthogonal zur Dickenrichtung ist seine Breite b₂. Die zweite Substratöffnung 22 wird durch die innere Stirnseite 25 begrenzt. Der Radius r₄ der zweiten Substratöffnung ist größer als der Radius r₁ des Substrates 91 und entspricht dem Radius r₃.

Es ist insbesondere in Fig. 3c zu erkennen, dass der Rahmen 21 des zweiten Trägerelementes 20 einen ersten Abschnitt 28 und einen zweiten Abschnitt 29 aufweist. Der erste Abschnitt 28 erstreckt sich in Breitenrichtung von der inneren Stirnseite 25 in Richtung der äußeren Stirnseite 26 des Rahmens 21, während sich der zweite Abschnitt 29 in Breitenrichtung von der äußeren Stirnseite 26 in Richtung der inneren Stirnseite 25 des Rahmens 21 erstreckt. Zwischen dem ersten Abschnitt 28 und dem zweiten Abschnitt 29 liegt eine Grenzfläche 71, die sich in Dickenrichtung und Umfangsrichtung des Rahmens 21 erstreckt. Von der Grenzfläche 71 verjüngt sich der erste Abschnitt 28 in Richtung der inneren Stirnseite 25 des Rahmens 21. Der erste Abschnitt besitzt daher an der inneren Stirnseite 25 des Rahmens 21 eine geringere Dicke als an der Grenzfläche 71, in der er die Dicke des zweiten Abschnittes 29 besitzt.

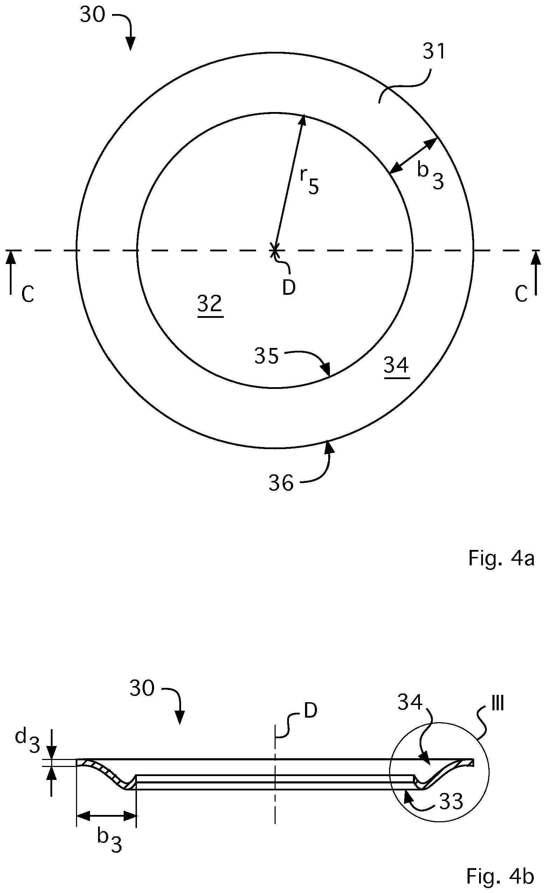

Das in den Figuren 4a bis 4c gezeigte Klemmelement 30 besitzt einen umlaufenden Rahmen 31, der eine dritte Substratöffnung 32 mit kreisförmigem Querschnitt umgrenzt. Der Rahmen besitzt eine Innenseite 33, eine Außenseite 34, eine umlaufende innere Stirnseite 35, die der dritten Substratöffnung 32 zugewandt ist, und eine umlaufende äußere Stirnseite 36, die der dritten Substratöffnung 32 abgewandt ist. Der Abstand zwischen der Innenseite 33 und der Außenseite 34 ist seine Dicke, der Abstand zwischen den beiden Stirnseiten 35, 36 orthogonal zur Dickenrichtung ist seine Breite. Die dritte Substratöffnung 32 wird durch die innere Stirnseite 35 begrenzt. Der Radius r₅ der dritten Substratöffnung ist kleiner als der Radius r₁ des Substrates 91 und kleiner als der Radius r₂ der ersten Substratöffnung 12.

Es ist insbesondere in Fig. 4c zu erkennen, dass der Rahmen 31 des Klemmelementes 30 einen ersten Abschnitt 37 und einen zweiten Abschnitt 38 aufweist. Der erste Abschnitt 37 ist an der Außenseite 24 des Rahmens 21 des zweiten Trägerelementes 20 befestigt. Der zweite Abschnitt 38 liegt, wenn das Substrat 91 im verbundenen Zustand der Trägervorrichtung 1 mit seiner Unterseite 93 auf dem Haltebereich anliegt, an der Oberseite 92 des Substrates 91 an. Der zweite Abschnitt 38 besitzt eine Krümmung, die, bezogen auf die Oberseite 92 des gehaltenen Substrates 91, eine konkave Krümmung sein kann. Der zweite Abschnitt liegt nur im Bereich des Scheitelpunktes 81 der Krümmung an der Oberseite 92 des gehaltenen Substrates 91 an. Der erste Abschnitt 37 verläuft in Dickenrichtung versetzt zu dem zweiten Abschnitt 38. Er ist dabei in Richtung der Innenseite 23 des Rahmens 21 des zweiten Trägerelementes versetzt.

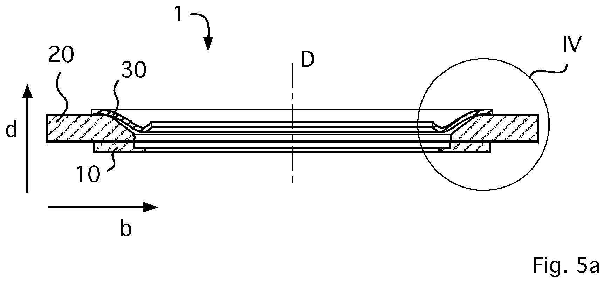

Fig. 5a zeigt die in den Figuren 2 bis 4 dargestellten Elemente 10, 20 und 30 im verbundenen Zustand der Trägervorrichtung 1. Das Substrat ist nicht dargestellt. Es ist zu erkennen, dass die erste, zweite und dritte Substratöffnung 12, 22, 32 im verbundenen Zustand fluchtend zueinander auf der Achse D liegen. Dabei grenzt die Innenseite 13 des Rahmens 11 des ersten Trägerelementes 10 an die Innenseite 23 des Rahmens 21 des zweiten Trägerelementes 20 an. Das Klemmelement 30 liegt mit der Innenseite 33 seines Rahmens 31 an der Außenseite 24 des Rahmens 21 des zweiten Trägerelementes an.

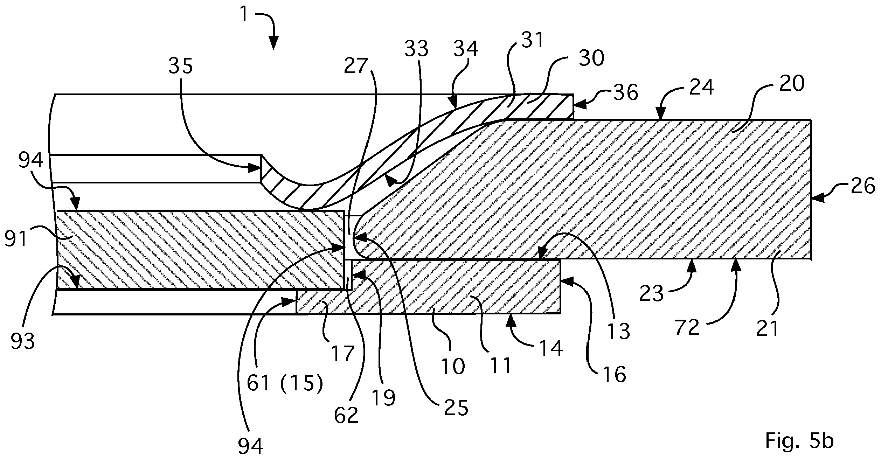

Fig. 5b zeigt das Detail IV von Fig. 5a und zusätzlich einen Teil des Substrates 91. Es ist zu erkennen, dass das Substrat 91 mit seiner Unterseite 93 in seinem Auflagebereich 95 auf der Oberseite 18 des Stegs 17, die den Haltebereich des Rahmens 11 des ersten Trägerelementes 10 bildet, aufliegt. Dabei ist zwischen dem Rand 94 des Substrates 91 und der ersten Kante 19 des Rahmens 11 ist ein umlaufender Spalt 62 ausgebildet. Das Substrat 91 liegt nur mit seinem Auflagebereich 95 an dem ersten Trägerelement 10 auf. Sein Rand 94 ist jedoch in Breitenrichtung des ersten Trägerelementes 10 von diesem beabstandet. Es ist ferner zu erkennen, das die Dicke d_{S} des Substrates 91 größer als die Dicke d₁ des Rahmens des ersten Trägerelementes 10 ist. Aus diesem Grund steht das Substrat in Dickenrichtung über die Innenseite 13 des Rahmens 11 über. Zwischen dem Rand 94 des Substrates 91 und inneren Stirnseite 25 des Rahmens 21 ist ein umlaufender Spalt 27 ausgebildet. Das Substrat 91 kontaktiert das zweite Trägerelement 20 nicht. Der Rand 94 des Substrates 91 ist in Breitenrichtung des zweiten Trägerelementes 20 von diesem beabstandet. Es ist ferner zu erkennen, das die Dicke des Rahmens 21 an seiner inneren Stirnseite 25 geringer als die Ausdehnung des in Dickenrichtung aus dem ersten Trägerelement 10 überstehenden Teiles des Substrates 91 ist. An seiner äußeren Stirnseite 26 ist die Dicke des Rahmens 21 größer als diese Ausdehnung.

Es ist ferner in Fig. 5b zu erkennen, dass die Ausdehnung des Rahmens 11 des ersten Trägerelementes 10 in Breitenrichtung geringer als die Ausdehnung des Rahmens 21 des zweiten Trägerelementes 20 ist. Damit wird der Rahmen 21 an seiner Innenseite 23 in einem Bereich 72 im verbundenen Zustand nicht von der Innenseite 13 des Rahmens 11 des ersten Trägerelementes 10 bedeckt.

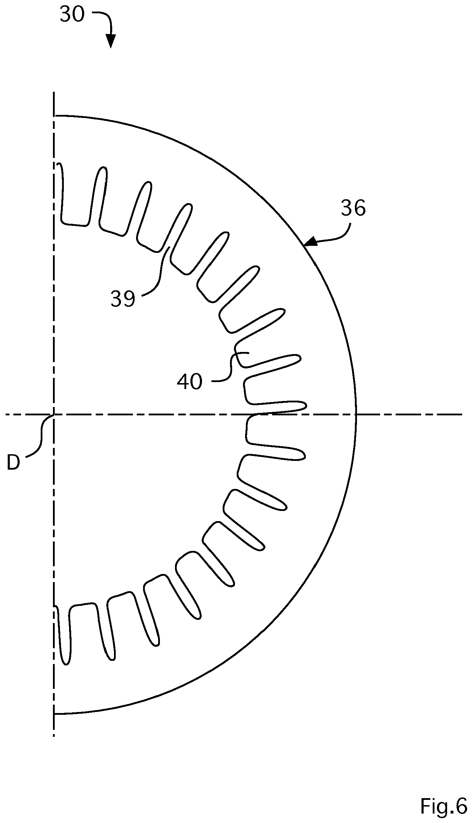

Fig. 6 zeigt eine Ausführungsform eines Klemmelementes 30, das Ausschnitte 39 aufweist. Die Ausschnitte 39 sind an der inneren Stirnseite 35 des Rahmens 31 ausgebildet. Die Ausschnitte 39 erstrecken sich von der inneren Stirnseite 35 in Richtung der äußeren Stirnseite 36 des Rahmens 31. Die Ausschnitte 39 sind äquidistant in Umfangsrichtung über den Rahmen 31 verteilt. Zwischen den Ausschnitten 39 liegen Bereiche 40, die im geschlossenen Zustand der Trägervorrichtung 1 jeweils eine Klemmwirkung auf das gehaltene Substrat 91 ausüben. Es in Fig. 6 zu erkennen, dass die Bereiche 40 abgerundete Kanten aufweisen.

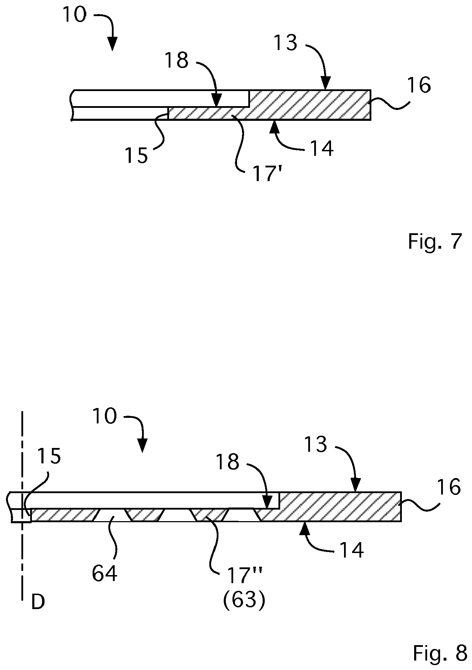

Die in Fig. 7 gezeigte weitere Ausführungsform eines ersten Trägerelementes 10 entspricht der in Fig. 2 gezeigten Ausführungsform, außer dass der Steg 17 durch einen Steg 17' ersetzt ist, der sich von Steg 17 durch eine größere Ausdehnung in Dickenrichtung unterscheidet. Damit wird ein größerer Haltebereich erreicht.

Die in Fig. 8 gezeigte weitere Ausführungsform eines ersten Trägerelementes 10 entspricht der in Fig. 2 gezeigten Ausführungsform, außer dass der Steg 17 durch einen Steg 17" ersetzt ist, der als Maske 63 ausgebildet ist. Der Steg 17" unterscheidet sich von Steg 17 durch eine größere Ausdehnung in Dickenrichtung und durch die Ausbildung von Öffnungen 64, die sich von der Oberseite des Steges 17" bis zu dessen Unterseite erstrecken.

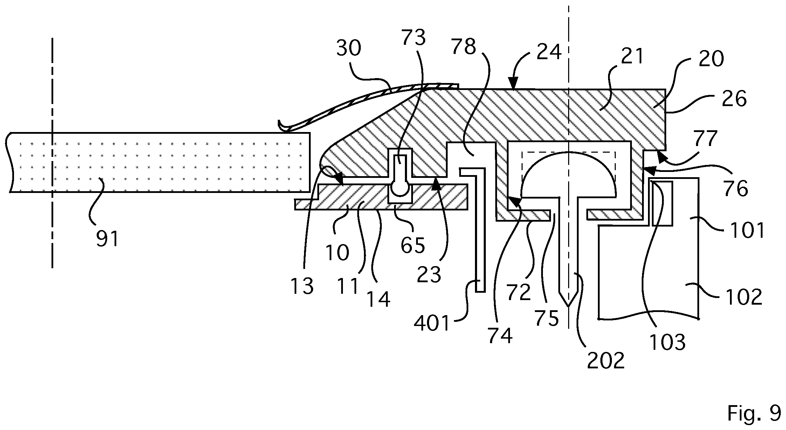

Die in Fig. 9 gezeigte zweite Ausführungsform einer Trägervorrichtung 1 entspricht der in Fig. 5 gezeigten Ausführungsform, außer dass zusätzlich Mittel zur Verbindung der beiden Trägerelemente 10, 20, zur Handhabung, zur Fixierung und und zur Be- und Entladung der Trägervorrichtung 1 gezeigt sind.

Es ist in Fig. 9 zu erkennen, dass an der Innenseite 13 des Rahmens 11 des ersten Trägerelementes 10 Positionsbohrungen 65 ausgebildet sind. An der Innenseite 23 des Rahmens 21 des zweiten Trägerelementes 20 sind korrespondierend Positionierstifte 73 angeordnet. Zur Herstellung des verbundenen Zustandes werden die Positionierstifte 73 in die Positionsbohrungen 65 eingeführt, wodurch eine Positionierung des zweiten Trägerelementes 20 am ersten Trägerelement 10 erreicht wird.

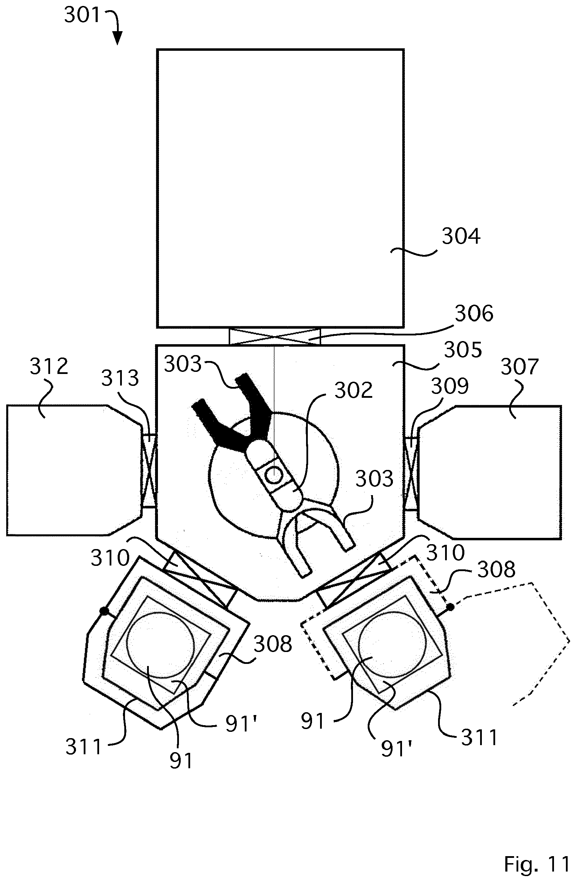

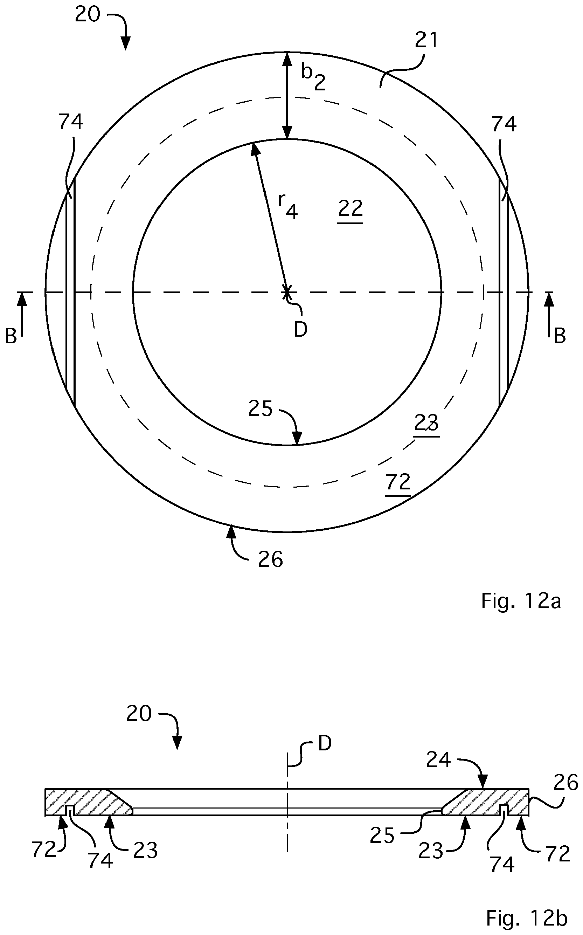

Im freiliegenden Bereich 72 der Innenseite 23 des Rahmens 21 des zweiten Trägerelementes ist eine C-Nut 74 ausgebildet, in die Spannköpfe 201 eingeführt werden, mit denen die Trägervorrichtung 1 im verbundenen Zustand in einer vorgegebenen Position fixiert werden kann. Mittels der Spannköpfe 201 kann die Trägervorrichtung 1 im verbundenen Zustand gegen ein Widerlager (nicht gezeigt) nach oben oder unten bewegt und damit fixiert werden. Die Spannköpfe 201 und das Widerlager können Teil einer Handhabevorrichtung 101 und/oder einer Fixierungseinrichtung, die beispielsweise in der Prozesskammer 304 (siehe Fig. 11) angeordnet sein kann, sein. Die Öffnung 75 der C-Nut befindet sich an der Innenseite 23 des Rahmens 21. Es ist insbesondere in den Figuren 12a und 12b zu erkennen, dass an der Innenseite 23 zwei parallele C-Nuten 74 ausgebildet sind. Die C-Nuten 74 erstrecken sich entlang von Sekanten, die die äußere Stirnseite 26 des Rahmes 21 jeweils zweimal schneiden. Damit sind die C-Nuten 74 an der äußeren Stirnseite 26 offen, so dass Spannköpfe 201 in die C-Nuten 74 eingeführt werden können. Abgesehen von den C-Nuten 74 entspricht die in den Figuren 12a und 12b gezeigte Ausführungsform des zweiten Trägerelementes der in den Fig. 3a bis 3c gezeigten Ausführungsform.

An der äußeren Stirnseite 26 des Rahmens 21 des zweiten Trägerelementes 20 ist eine Greifstelle 76 zum Eingriff eines Fingers 102 einer Handhabevorrichtung 101 ausgebildet. Die Greifstelle 76 erstreckt sind in den freiliegenden Bereich 72 der Innenseite 23 des Rahmens 21. An der Greifstelle 76 kann ein Formelement 77 ausgebildet sein, in das ein korrespondierendes Formelement 103, das an dem Finger 102 der Handhabevorrichtung 101 ausgebildet ist, unter Herstellung eines Formschlusses eingreifen kann. Die Formelemente 77, 103 dienen somit als Positionierungselemente.

Um die Be- und Entladung der Trägervorrichtung zu ermöglichen, kann eine Ladevorrichtung 307 (siehe Fig. 11) vorgesehen sein. Die Ladevorrichtung 307 weist Fixierungselemente 401 auf. Die Fixierungselemente 401 sind so ausgebildet, dass sie den Rahmen 11 des ersten Trägerelementes 10 an dessen äußerer Stirnseite 16 und einen daran angrenzenden Bereich der Innenseite 13 umschließen. An der Innenseite 23 des Rahmens 21 des zweiten Trägerelementes 10 ist eine Ausnehmung 78 ausgebildet, um die Fixierung des ersten Trägerelementes 10 mittels der Fixierungselemente 401 zu ermöglichen

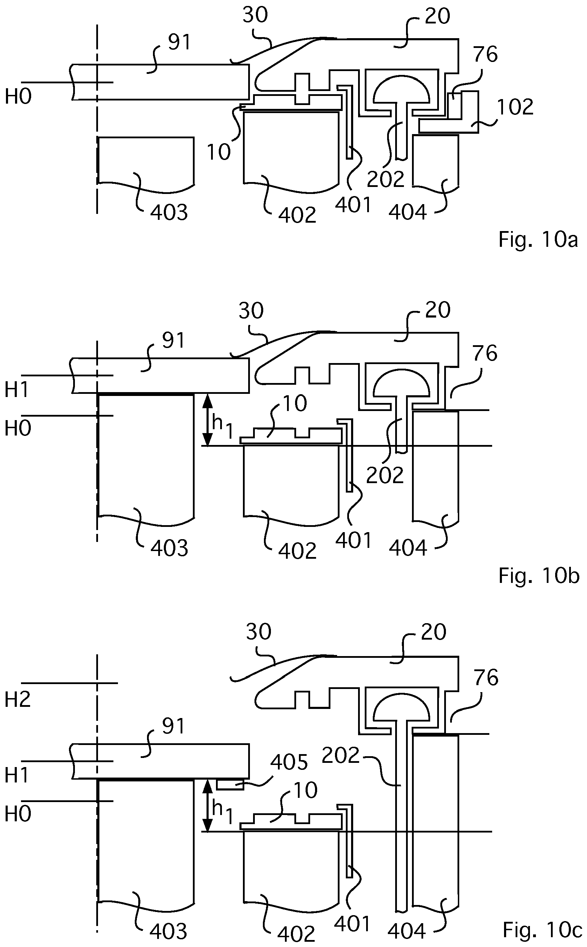

Fig. 10 veranschaulicht die Entladung einer Trägervorrichtung 1. In Fig. 10a befindet sich die Trägervorrichtung 1, die ein Substrat 91 hält, im verbundenen Zustand und liegt in der Ladevorrichtung 307, wobei die Flächenseiten 92, 93 des gehaltenen Substrates 91 in einer horizontalen Ebene liegen. Die Ladevorrichtung 307 weist eine Basisauflage 402 auf, auf der die Trägervorrichtung 1 mit der Außenseite 14 des Rahmens 11 des ersten Trägerelementes 10 aufliegt, während das Substrat 91 an seiner Unterseite 93, abgesehen vom Auflagebereich 95, und an seiner Oberseite 92 freiliegt. Mittels der Fixierungselemente 401 der Ladevorrichtung 307 ist das erste Trägerelement 10 an der Basisauflage 402 fixiert. In die Ladevorrichtung 307 ist die Trägervorrichtung 1 mittels der Handhabevorrichtung 101 eingebracht worden, deren Finger 102 in die Greifstelle 76 an dem zweiten Trägerelement 20 eingreift. Der Finger 102 wird anschließend aus der Greifstelle 76 gelöst und weggeführt. Bei der Ladevorrichtung 307 kann es sich um eine Trägervorrichtungs-Wechselstation (siehe Fig. 11) handeln

Die Trägervorrichtung 1 wird nun in zwei Stufen durch Ausführung einer Hubbewegung angehoben. Dazu weist die Ladevorrichtung 307 Hubelemente 403, 404 auf. Das erste Hubelement 403 wird in Kontakt mit der Unterseite 93 des Substrates 91 gebracht. Das zweite Hubelement 404 wird in Kontakt mit dem freiliegenden Bereich 72 der Innenseite 23 des zweiten Trägerelementes 20 gebracht. Durch eine synchrone Hubbewegung mittels des ersten und zweiten Hubelements 403, 404 werden das Substrat 91 und das zweite Trägerelement 20 in eine erste Höhe H1 um eine Strecke h₁ angehoben, während das erste Trägerelement 10 mittels der Fixierungselemente 401 in der Ausgangshöhe H0 gehalten wird (Fig. 10b) Damit sind das Substrat 91 und das zweite Trägerelement 20 vom ersten Trägerelement 10 gelöst.

Anschließend wird nun das zweite Trägerelement 20 mittels des zweiten Hubelementes 404 auf eine zweite Höhe H2 um eine Strecke h₂ angehoben. Das auf dem ersten Hubelement 403 aufliegende Substrat 91 liegt nun an seiner Oberseite frei und kann mittels eines zweiten Fingers 405 der Ladevorrichtung 307 aus der zweiten Ladevorrichtung entnommen werden (Fig. 10c).

Zur Beladung der erfindungsgemäßen Trägervorrichtung 1 kann nun mittels des Fingers 405 ein anderes Substrat 91 auf das erste Hubelement 403 aufgelegt, das zweite Trägerelement 20 von der Höhe H2 in die Höhe H1 mittels des zweiten Hubelementes 404 abgesenkt und anschließend synchron das erste und zweite Hubelement 403, 404 in Höhe H0 abgesenkt werden, wodurch die Trägervorrichtung 1 wieder in die verbundenen Zustand überführt wird. Mittels der Handhabevorrichtung 101 kann die Trägervorrichtung 1 nun aus der Ladevorrichtung 307 entnommen werden, wozu Finger 102 in die Greifstelle 76 an dem zweiten Trägerelement 20 eingreift.

Fig. 11 zeigt eine Vorrichtung zur Bearbeitung flacher Substrate 91. Die Vorrichtung ist eine Druckprozessanlage 301. Sie weist eine Prozesskammer 304 auf, in der flache Substrate 91 bearbeitet werden können. Die Prozesskammer 304 ist mit einer Handhabungskammer 305 über ein Schleusenventil 306 verbunden. An der Handhabungskammer 305 sind eine Trägervorrichtungs-Wechselstation 307, eine Trägervorrichtungs-Magazinstation 312 und zwei Ladeschleusen 308 angeordnet. Die Trägervorrichtungs-Wechselstation 307 ist mit der Handhabungskammer 305 über ein Schleusenventil 309 verbunden. Die Trägervorrichtungs-Magazinstation 312 ist mit der Handhabungskammer 305 über ein Schleusenventil 313 verbunden. Die Ladeschleusen 308 sind mit der Handhabungskammer 305 über Substrat-Schleusenventile 310 verbunden, die Teil der Ladeschleusen 308 sind. Einzelheiten zu den Ladeschleusen 308 sind in der deutschen Patentanmeldung Nr. 10 2018 102 762.1 (unveröffentlicht) beschrieben. Die Trägervorrichtungs-Magazinstation 312 dient zur Zwischenlagerung von Trägervorrichtungen 1 innerhalb der Druckprozessanlage 301. Auf diese Weise können Trägervorrichtungen 1 unter den Druckbedingungen, die in der Handhabungskammer 305 herrschen, gelagert werden.

In der Handhabungskammer 305 befindet sich die Handhabungseinrichtung 302 mit ihren Greifarmen 303. Mittels der Handhabungseinrichtung 302 kann ein Substrat 91 aus einem Substratbehälter 311, der sich in einer der Ladeschleusen 308 befindet, entnommen und in eine Trägervorrichtungs-Wechselstation 307 überführt werden und umgekehrt. In der Trägervorrichtungs-Wechselstation 307 kann das Substrat 91 in eine Trägervorrichtung 1 eingelegt oder aus ihr entnommen werden, d. h. in der Trägervorrichtungs-Wechselstation 307 findet die Be- und Entladung der Trägervorrichtung 1 statt. Mittels der Handhabungseinrichtung 302 kann ferner eine Trägervorrichtung 1, die ein Substrat 91 hält oder halten kann, aus einer Trägervorrichtungs-Wechselstation 307 entnommen und in Prozesskammer 304 überführt werden und umgekehrt. Dazu kann sich die Handhabungseinrichtung 302 mit dem von dem Greifarm 303 gehaltenen Substrat 91 innerhalb der Handhabungskammer 305 um eine vertikale Achse drehen (Doppelpfeil C).

Mittels der Handhabungseinrichtung 302 kann ferner eine Trägervorrichtung 1 aus der Trägervorrichtungs-Magazinstation 312 entnommen und in eine Trägervorrichtungs-Wechselstation 307 überführt werden und umgekehrt.

In Fig. 11 ist in beiden Ladeschleusen 308 zusätzlich zu einem flachen Substrat 91, das einen kreisförmigen Querschnitt aufweist, ein flaches Substrat 91' mit quadratischem Querschnitt gezeigt.

Der Einsatz der erfindungsgemäßen Trägervorrichtung in Verbindung mit den in der deutschen Patentanmeldung Nr. 10 2018 102 762.1 (unveröffentlicht) beschriebenen Ladeschleusen ist besonders vorteilhaft. Damit wird eine prozesssichere, platzsparende und damit ökonomische Bearbeitung von Substraten, insbesondere unter vom Umgebungsdruck abweichenden Druckverhältnissen erreicht.

### Bezugszeichenliste

- 1: Trägervorrichtung

- 10: erstes Trägerelement
- 11: Rahmen
- 12: erste Substratöffnung
- 13: Innenseite
- 14: Außenseite
- 15: Innere Stirnseite
- 16: äußere Stirnseite
- 17: Steg
- 18: Oberseite
- 19: erste Kante

- 20: zweites Trägerelement
- 21: Rahmen
- 22: zweite Substratöffnung
- 23: Innenseite
- 24: Außenseite
- 25: Innere Stirnseite
- 26: äußere Stirnseite
- 27: Spalt
- 28: erster Abschnitt
- 29: zweiter Abschnitt

- 30: Klemmelement
- 31: Rahmen
- 32: dritte Substratöffnung
- 33: Innenseite
- 34: Außenseite
- 35: Innere Stirnseite
- 36: äußere Stirnseite
- 37: erster Abschnitt
- 38: zweiter Abschnitt
- 39: Ausschnitt
- 40: Bereich

- 71: Grenzfläche
- 72: Bereich
- 73: Positionierstift
- 74: C-Nut
- 75: Öffnung
- 76: Greifatelle
- 77: Formelement
- 78: Ausnehmung

- 81: Scheitelpunkt

- 91: Substrat
- 92: Oberseite
- 93: Unterseite
- 94: Rand
- 95: Auflagebereich

- 101: Handhabevorrichtung
- 102: Finger
- 103: Formelement

- 201: Spannkopf

- 301: Druckprozessanlage
- 302: Handhabungseinrichtung
- 303: Greifarm
- 304: Prozesskammer
- 305: Handhabungskammer
- 306: Schleusenventil
- 307: Trägervorrichtungs-Wechselstation
- 308: Ladeschleuse
- 309: Schleusenventil
- 310: Substrat-Schleusenventil
- 311: Substratbehälter
- 312: Trägervorrichtungs-Magazinstation
- 313: Schleusenventil

- 401: Fixierungselement
- 402: Basisauflage
- 403: erstes Hubelement
- 404: zweites Hubelement

## Patentansprüche

1. Trägervorrichtung für ein flaches Substrat, wobei die Trägervorrichtung (1) ein erstes Trägerelement (10), ein zweites Trägerelement (20) und ein Klemmelement (30) aufweist, wobei das erste und das zweite Trägerelement (10, 20) miteinander unter Ausbildung eines verbundenen Zustandes lösbar verbindbar sind, **dadurch gekennzeichnet, dass**
- das erste Trägerelement (10) einen unter Ausbildung einer ersten Substratöffnung (12) umlaufenden Rahmen (11) aufweist, der eine der ersten Substratöffnung (12) zugewandte Stirnseite (15) besitzt, wobei an der Stirnseite (15) ein Steg (17) mit einer Oberseite (18) ausgebildet ist, die einen Haltebereich für das Substrat (91) bildet, so dass dieses mit einem Auflagebereich (95), der an einer Flächenseite (93) des Substrates (91) ausgebildet ist und an den Rand (94) des Substrates (91) angrenzt, auf dem Haltebereich aufliegen kann;
- das zweite Trägerelement (20) einen unter Ausbildung einer zweiten Substratöffnung (22) umlaufenden Rahmen (21) aufweist, der eine Innenseite (23) aufweist, die im verbundenen Zustand auf einer Innenseite (13) des ersten Trägerelementes (10) aufliegt, so dass die erste Substratöffnung (12) und die zweite Substratöffnung (22) fluchtend zueinander ausgerichtet sind, und das zweite Trägerelement (20) das Klemmelement (30) trägt; und
- das Klemmelement (30) das Substrat (91), wenn es im verbundenen Zustand mit einer Flächenseite (93) auf dem Haltebereich aufliegt, an seiner anderen Flächenseite (92) kontaktiert und gegen den Steg (17) des ersten Trägerelementes (10) presst.

2. Trägervorrichtung nach Anspruch 1, **dadurch gekennzeichnet, dass** seine Ausdehnung orthogonal zur Dickenrichtung des ersten Trägerelementes (10) und/oder des zweiten Trägerelementes (20) größer als seine Ausdehnung in Dickenrichtung ist.

3. Trägervorrichtung nach Anspruch 1 oder Anspruch 2, **dadurch gekennzeichnet, dass** das erste Trägerelement (10) und/oder das zweite Trägerelement (20) aus Stahl, Leichtmetall, einer Leichtmetalllegierung, Kunststoff, einer Keramik oder einem Glas bestehen.

4. Trägervorrichtung nach einem der vorstehenden Ansprüche, **dadurch gekennzeichnet, dass** im verbundenen Zustand die Innenseiten (13, 23) des ersten Trägerelementes (10) und des zweiten Trägerelementes (20) formschlüssig aneinander anliegen.

5. Trägervorrichtung nach einem der vorstehenden Ansprüche, **dadurch gekennzeichnet, dass** sich der Steg (17), der an der Stirnseite (15) des Rahmens (11) des ersten Trägerelementes (10) ausgebildet ist, von der Außenseite (14) des Rahmens (11) in Richtung der Innenseite (13) des Rahmens (11) erstreckt, so dass die Oberseite (18) des Steges (17) in Dickenrichtung zur Innenseite (13) des Rahmens (11) versetzt ist und eine erste umlaufende Kante (19), die sich von der Innenseite (13) des Rahmens (11) bis zur Oberseite (18) des Steges (17) erstreckt, bildet, wobei der Abstand zwischen gegenüberliegenden Abschnitten der ersten umlaufenden Kante (19) größer als die Ausdehnung des Substrates (91) in Flächenrichtung ist.

6. Trägervorrichtung nach einem der vorstehenden Ansprüche, **dadurch gekennzeichnet, dass** das Klemmelement (30) einen unter Ausbildung einer dritten Substratöffnung (32) umlaufenden Rahmen (31) aufweist, wobei die zweite Substratöffnung (22) und die dritte Substratöffnung (32) fluchtend zueinander ausgerichtet sind.

7. Trägervorrichtung nach einem der vorstehenden Ansprüche, **dadurch gekennzeichnet, dass** das Klemmelement (30) aus einem Federmaterial besteht.

8. Trägervorrichtung nach einem der vorstehenden Ansprüche, **dadurch gekennzeichnet, dass** das Klemmelement (30) aus Edelstahl oder Kunststoff besteht.

9. Trägervorrichtung nach einem der vorstehenden Ansprüche, **dadurch gekennzeichnet, dass** das Klemmelement (30) einen ersten Abschnitt (37) und einen zweiten Abschnitt (38) aufweist, wobei der erste Abschnitt (37) an der Außenseite (24) des zweiten Trägerelementes (20) befestigt ist und der zweite Abschnitt (38), wenn das Substrat (91) im verbundenen Zustand mit einer Flächenseite (93) auf dem Haltebereich aufliegt, an der anderen Flächenseite (94) des Substrates (91) anliegt, wobei der erste Abschnitt (37) versetzt zum zweiten Abschnitt (38) verläuft.

10. Trägervorrichtung nach einem der vorstehenden Ansprüche, **dadurch gekennzeichnet, dass** das Klemmelement (30) einen oder mehrere Ausschnitte (39) aufweist, wobei die Ausschnitte (39) an einer Stirnseite (35) des Klemmelementes (30) ausgebildet sind, die der dritten Substratöffnung (32) zugewandt ist.

11. Trägervorrichtung nach einem der vorstehenden Ansprüche, **dadurch gekennzeichnet, dass** sie Positionierstifte für die Positionierung des zweiten Trägerelementes (20) an dem ersten Trägerelement (10) aufweist.

12. Trägervorrichtung nach einem der vorstehenden Ansprüche, **dadurch gekennzeichnet, dass** der am ersten Trägerelement (10) ausgebildete Steg (17) in Form einer Maske ausgebildet ist.

13. Trägervorrichtung nach einem der vorstehenden Ansprüche, **dadurch gekennzeichnet, dass** das erste Trägerelement (10) und/oder das zweite Trägerelement (20) einen oder mehrere Magnete zur lösbaren Verbindung der beiden Trägerelemente (10, 20) aufweisen.

14. Handhabevorrichtung für eine Trägervorrichtung nach einem der Ansprüche 1 bis 13, **dadurch gekennzeichnet, dass** die Handhabevorrichtung (101) einen Finger (102) zum Eingriff in eine Greifstelle aufweist, die an dem zweiten Trägerelement (20) ausgebildet ist.

15. Handhabevorrichtung nach Anspruch 14, **dadurch gekennzeichnet, dass** der Finger (102) zumindest ein Positionierungselement (103) zum Zusammenwirken mit einem korrespondierten Positionierungselement aufweist, das an dem zweiten Trägerelement (20) ausgebildet ist.
